# EUROPEAN PATENT SPECIFICATION

(11) **EP 4 503 106 B1**
(45) Date of publication and mention of the grant of the patent: **06.05.2026**
(21) Application number: 24166865.6
(22) Date of filing: 27.03.2024
(51) Int. Cl.: H10W 72/00, H10W 70/60, H10B 80/00

(54) **SEMICONDUCTOR CHIP STRUCTURE**
HALBLEITERCHIPSTRUKTUR
STRUCTURE DE PUCE SEMI-CONDUCTRICE

(30) Priority: 03.08.2023 KR 20230101792
(43) Date of publication of application: 05.02.2025
(73) Proprietor: Samsung Electronics Co., Ltd., Suwon-si, Gyeonggi-do 16677 (KR)
(72) Inventor: SEO, Jubin, 16677 Suwon-si (KR); LIM, Dongchan, 16677 Suwon-si (KR); PARK, Sujeong, 16677 Suwon-si (KR); LEE, Junkyoung, 16677 Suwon-si (KR)
(74) Representative: Marks & Clerk LLP

(56) References cited:
- CN-A- 116 487 353
- US-A1- 2022 285 208
- US-A1- 2023 197 453
- US-A1- 2023 307 392

## Description

### 1. TECHNICAL FIELD

The present inventive concept relates to a semiconductor chip structure, and more particularly, to a semiconductor chip structure including a pad structure.

### 2. DISCUSSION OF RELATED ART

As semiconductor chips are highly integrated, there has been research conducted concerning semiconductor chip structures that are manufactured by bonding a first semiconductor chip to a second semiconductor chip. Semiconductor chip structures manufactured by bonding a first semiconductor chip to a second semiconductor chip should have a high bonding reliability. When the bonding reliability is not good during the manufacturing process, semiconductor chip structures having the first semiconductor chip bonded to the second semiconductor chip may not perform properly. US2022/285208Al discloses a semiconductor chip structure including a first chip that includes a first chip region and a first scribe lane region and a second chip that includes a second chip region and a second scribe lane region respectively bonded to the first chip region and the first scribe lane. CN116487353A discloses structures and methods for direct bonding.

### SUMMARY

Embodiments of the present inventive concept provides a semiconductor chip structure which increases the bonding reliability of a first semiconductor chip and a second semiconductor chip.

The invention is defined in claim 1. Preferred embodiments are set out in the dependent claims. The semiconductor chip has a first semiconductor chip including a first chip region and a first scribe lane. The first semiconductor chip is bonded to a second semiconductor chip including a second chip region and a second scribe lane region respectively corresponding to the first chip region and the first scribe lane region. The first semiconductor chip comprises a first final wiring layer including a first final wiring pattern and a first passivation layer insulating the first final wiring pattern. A first bonding wiring layer is disposed on the first final wiring layer. The first bonding wiring layer includes a first bonding insulation layer and a first bonding electrode disposed in the first bonding insulation layer. The second semiconductor chip includes a second final wiring layer including at least one second final wiring pattern, a polish stop pattern disposed on the at least one second final wiring pattern, and a second passivation layer insulating the at least one second final wiring pattern and the polish stop pattern. A second bonding wiring layer is disposed on the second final wiring layer. The second bonding wiring layer includes a second bonding insulation layer and a second bonding electrode disposed in the second bonding insulation layer and the polish stop pattern. The first bonding insulation layer and the first bonding electrode of the first bonding wiring layer are respectively hybrid-bonded to the second bonding insulation layer and the second bonding electrode of the second bonding wiring layer. At least a portion of a bonding interface between the hybrid-bonded first bonding insulation layer and the first bonding electrode of the first bonding wiring layer to the second bonding insulation layer and the second bonding electrode of the second bonding wiring layer comprises fine grain copper, and a remaining portion of the bonding interface and an inner portion of each of the first bonding electrode and the second bonding electrode comprise nanotwin copper, wherein the fine grain copper is not disposed at an edge of an uppermost surface of the first bonding electrode and an edge of an uppermost surface of the second bonding electrode.

### BRIEF DESCRIPTION OF THE DRAWINGS

Embodiments will be more clearly understood from the following detailed description taken in conjunction with the accompanying drawings in which:
FIG. 1 is a cross-sectional view for describing a semiconductor chip structure according to an embodiment;
FIG. 2 is a partial cross-sectional view for describing the semiconductor chip structure of FIG. 1;
FIGS. 3A to 3C are partial cross-sectional views for describing a semiconductor chip structure according to an embodiment;
FIGS. 4 to 13 are cross-sectional views for describing a method of manufacturing a semiconductor chip structure according to an embodiment illustrated in FIGS. 1 and 2;
FIG. 14 is a cross-sectional view for describing a semiconductor chip structure according to an embodiment;
FIGS. 15 and 16 are cross-sectional views for describing a method of manufacturing the semiconductor chip structure of FIG. 14;
FIG. 17 is a block diagram schematically illustrating a memory card to which a semiconductor package including a semiconductor chip structure according to an embodiment is applied; and
FIG. 18 is a block diagram schematically illustrating an electronic system to which a semiconductor package including a semiconductor chip structure according to an embodiment is applied.

### DETAILED DESCRIPTION OF EMBODIMENTS

Hereinafter, embodiments will be described in detail with reference to the accompanying drawings. Like reference numerals refer to like elements in the drawings, and their repeated descriptions are omitted.

Embodiments of the present inventive concept are provided so that this disclosure will be thorough and complete, and will fully convey the concept of the present inventive concept to one of ordinary skill in the art. However, embodiments of the present inventive concept are not limited to the described embodiments and it should be understood that the present inventive concept covers all the modifications, equivalents, and replacements within the idea and technical scope of the present inventive concept, which is defined by the claims. In describing the present inventive concept, a detailed description of known techniques associated with the present inventive concept which may unnecessarily obscure the gist of the present inventive concept may be omitted.

Herein, a singular form of elements may include a plural form unless another case is clearly designated in context. Certain elements in the drawings may be exaggerated for more clearly describing the present inventive concept.

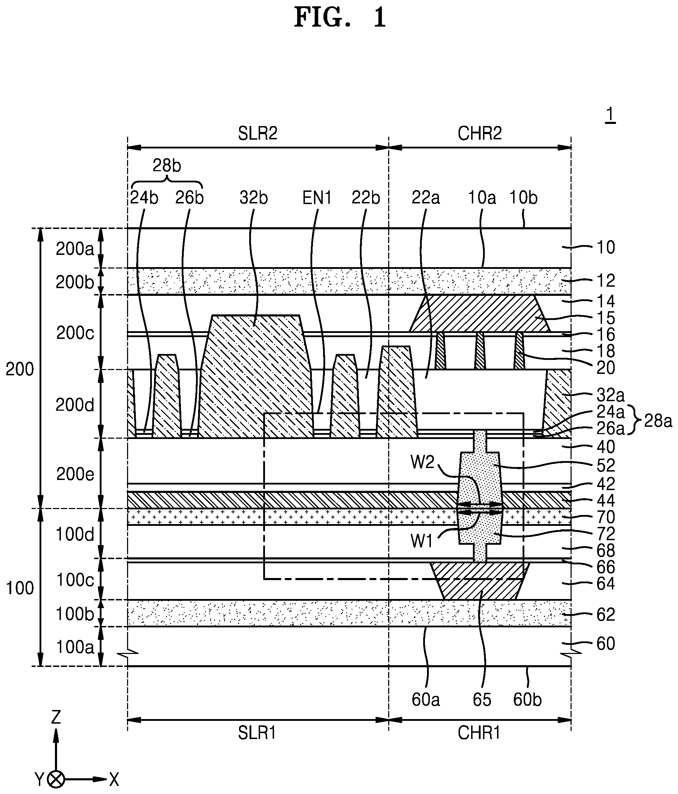

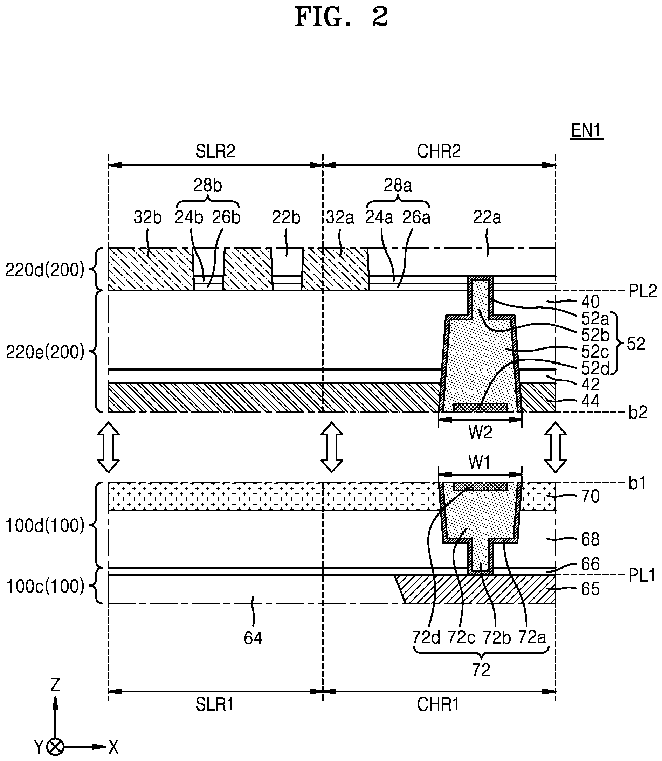

FIG. 1 is a cross-sectional view for describing a semiconductor chip structure 1 according to an embodiment, and FIG. 2 is a partial cross-sectional view for describing the semiconductor chip structure 1 of FIG. 1.

In detail, in FIGS. 1 and 2, an X direction and a Y direction are each a direction parallel to a surface 60a (e.g., an upper surface) of a first substrate 60 and a surface 10a of a second substrate 10. In an embodiment, a Z direction is a direction perpendicular to the surface 60a (e.g., an upper surface) of the first substrate 60 and the surface 10a of the second substrate 10. FIG. 2 is an enlarged cross-sectional view of a portion EN1 of the semiconductor chip structure 1 of FIG. 1.

The semiconductor chip structure 1 may be configured by bonding a second semiconductor chip 200 to a first semiconductor chip 100. In an embodiment, in the semiconductor chip structure 1, the first semiconductor chip 100 may be disposed at a lower portion (e.g., in the Z direction) and the second semiconductor chip 200 may be disposed at an upper portion (e.g., in the Z direction). However, embodiments of the present inventive concept are not necessarily limited thereto. For example, the first semiconductor chip 100 may be disposed at the upper portion of the semiconductor chip structure 1, and the second semiconductor chip 200 may be disposed at the lower portion of the semiconductor chip structure 1. Herein, for convenience, an upper surface or an upper portion of the first substrate 60 may be lower in the Z direction, and an upper surface or an upper portion of the second substrate 10 may be higher in the Z direction.

The first semiconductor chip 100 includes a first chip region CHR1 and a first scribe lane region SLR1. The first chip region CHR1 may be a region in which circuit elements (e.g., a transistor, a capacitor, a resistor, etc.) configuring the first semiconductor chip 100 are disposed. The first scribe lane region SLR1 may be a region which is secondarily formed in manufacturing the first chip region CHR1. The first scribe lane region SLR1 is spaced apart from the first chip region CHR1 (e.g., in the X direction). In an embodiment, the first scribe lane region SLR1 may be a region in which circuit elements are not provided.

The second semiconductor chip 200 includes a second chip region CHR2 and a second scribe lane region SLR2. The second chip region CHR2 may be a region in which circuit elements (e.g., a memory cell) configuring the second semiconductor chip 200 are disposed. The second scribe lane region SLR2 may be a region which is secondarily formed in manufacturing the second chip region CHR2. The second scribe lane region SLR2 is spaced apart from the second chip region CHR2 (e.g., in the X direction). In an embodiment, the second scribe lane region SLR2 may be a region in which circuit elements are not provided.

The semiconductor chip structure 1 may be configured by bonding the first semiconductor chip 100, including the first chip region CHR1 and the first scribe lane region SLR1, to the second semiconductor chip 200 including the second chip region CHR2 and the second scribe lane region SLR2 each corresponding thereto.

First, elements of the first semiconductor chip 100 and the second semiconductor chip 200 will be described in more detail.

In more detail, the first semiconductor chip 100 may include a first substrate layer 100a, a first circuit layer 100b, a first final wiring layer 100c, and a first bonding wiring layer 100d which may be arranged in the Z direction. The first substrate layer 100a may include a first substrate 60. The first substrate 60 may include the surface 60a (e.g., an upper surface) and a rear surface 60b disposed at a side opposite to the surface 60a (e.g., in the Z direction). In an embodiment, the first substrate 60 may be a silicon substrate. For example, the first substrate 60 may be a silicon wafer. The first substrate 60 may include the first chip region CHR1 and the first scribe lane region SLR1.

The first circuit layer 100b may be disposed on the first substrate 60, which includes the first chip region CHR1 and the first scribe lane region SLR1. The first circuit layer 100b may include a first circuit 62. The first circuit 62 may be disposed on (e.g., disposed directly thereon in the Z direction) the surface 60a of the first substrate 60. In an embodiment, the first circuit 62 may be a peripheral circuit. The peripheral circuit may include a circuit element (e.g., a transistor).

The first final wiring layer 100c may be disposed on (e.g., disposed directly thereon in the Z direction) the first circuit layer 100b. In an embodiment, the first final wiring layer 100c may include a first final wiring pattern 65, a first passivation layer 64 insulating the first final wiring pattern 65, and a first etch stop layer 66 disposed on (e.g., disposed directly thereon) the first passivation layer 64 and the first final wiring pattern 65.

The first final wiring pattern 65 may be electrically connected with the first circuit 62. In FIG. 1, the first final wiring pattern 65 is illustrated as being directly connected with the first circuit 62. However, embodiments of the present inventive concept are not necessarily limited thereto. For example, in an embodiment the first final wiring pattern 65 may be electrically connected with the first circuit 62 through a middle wiring pattern. The first final wiring pattern 65 may include a metal material.

In some embodiments, the first final wiring pattern 65 may include a metal material which differs from that of a first bonding electrode 72. In one embodiment, the first final wiring pattern and the first bonding electrode may respectively comprise a different metal material from each other. In some embodiments, the first final wiring pattern 65 may include aluminum, copper, tungsten, or the like. In some embodiments, the first final wiring pattern 65 may include a base metal (e.g., aluminum and an impurity element), and for example, may include a metal alloy including silicon.

The first passivation layer 64 may insulate the first final wiring pattern 65. In an embodiment, the first passivation layer 64 may include silicon oxide. For example, the first passivation layer 64 may include silicon oxide formed by a high density plasma (HDP) process. The first etch stop layer 66 may be formed for preventing damage to the first final wiring pattern 65 when forming the first bonding electrode 72. However, embodiments of the present inventive concept are not necessarily limited thereto and the first etch stop layer 66 may not be formed in some embodiments. In an embodiment, the first etch stop layer 66 may include silicon nitride.

The first bonding wiring layer 100d may be disposed on (e.g., in the Z direction) the first final wiring layer 100c. In an embodiment, the first bonding wiring layer 100d may include a first interlayer insulation layer 68, a first bonding insulation layer 70, and the first bonding electrode 72. The first interlayer insulation layer 68 may be disposed on (e.g., in the Z direction) the first passivation layer 64, the first final wiring pattern 65, and the first etch stop layer 66. In an embodiment, the first interlayer insulation layer 68 may include silicon oxide. For example, the first interlayer insulation layer 68 may include silicon oxide formed by an HDP process.

The first bonding insulation layer 70 may be disposed on (e.g., disposed directly thereon in the Z direction) the first interlayer insulation layer 68. In an embodiment, the first bonding insulation layer 70 may include at least one material selected from silicon carbide nitride (SiCN) and silicon oxide (SiO). The first bonding electrode 72 may be disposed in the first interlayer insulation layer 68 and the first bonding insulation layer 70.

The first bonding electrode 72 may include a metal material (e.g., copper, etc.). The first bonding electrode 72 may have an upper width and a lower width, which differ along the Z direction. The first bonding electrode 72 includes nanotwin copper and fine grain copper.
Detailed elements of the first bonding electrode 72 will be described below with reference to the drawings.

The second semiconductor chip 200 may include a second substrate layer 200a, a second circuit layer 200b, a middle wiring layer 200c, a second final wiring layer 200d, and a second bonding wiring layer 200e arranged in the Z direction. The second substrate layer 200a may include a second substrate 10. The second substrate 10 may include a surface 10a and a rear surface 10b disposed at a side opposite to the surface 10a (e.g., in the Z direction). In an embodiment, the second substrate 10 may be a silicon substrate. For example, the second substrate 10 may be a silicon wafer. The second substrate 10 may include a second chip region CHR2 and a second scribe lane region SLR2.

The second circuit layer 200b may be disposed on (e.g., disposed directly thereon in the Z direction) the second substrate 10, which includes the second chip region CHR2 and the second scribe lane region SLR2. In an embodiment, the second circuit layer 200b may include a second circuit 12. The second circuit 12 may be disposed on the surface 10a of the second substrate 10. The second circuit 12 may be driven by the first circuit 62.

In an embodiment, the second circuit 12 may include a memory cell. When the first circuit 62 and the second circuit 12 are detached from the semiconductor chip structure 1, thermal stress applied in performing a process on the first circuit 62 and the second circuit 12 may be optimized.

The middle wiring layer 200c may be disposed on (e.g., disposed directly thereon in the Z direction) the second circuit layer 200b. In an embodiment, the middle wiring layer 200c may include a first middle wiring insulation layer 14, a middle wiring pattern 15, a second etch stop layer 16, a second middle wiring insulation layer 18, and a middle wiring via 20. The middle wiring pattern 15 may be electrically connected with the second circuit 12.

The middle wiring pattern 15 may be insulated by the first middle wiring insulation layer 14. The middle wiring via 20 may be insulated by the second middle wiring insulation layer 18. In an embodiment, the middle wiring via 20 may be electrically connected with the middle wiring pattern 15 and may directly contact the middle wiring pattern 15. The middle wiring via 20 may include a plurality of via electrodes.

In an embodiment, the middle wiring pattern 15 and the middle wiring via 20 may include a metal material (e.g., aluminum, copper, tungsten, etc.). The first middle wiring insulation layer 14 and the second middle wiring insulation layer 18 may include silicon oxide. For example, the first middle wiring insulation layer 14 and the second middle wiring insulation layer 18 may include silicon oxide formed by an HDP process.

The second etch stop layer 16 may be formed for preventing damage to the middle wiring pattern 15 when forming the middle wiring via 20. However, embodiments of the present inventive concept are not necessarily limited thereto and the second etch stop layer 16 may not be formed in some embodiments. In an embodiment, the second etch stop layer 16 may include silicon nitride.

The second final wiring layer 200d may be disposed on (e.g., disposed directly thereon in the Z direction) the middle circuit layer 200c. In an embodiment, the second final wiring layer 200d may include second final wiring patterns 22a and 22b, polish stop patterns 28a and 28b, and second passivation layers 32a and 32b. The second final wiring patterns 22a and 22b may be electrically connected with the middle wiring pattern 15 through the middle wiring via 20. In one embodiment, the second passivation layer may insulate an at least one second final wiring pattern and a polish stop pattern.

The second final wiring patterns 22a and 22b may include the second final wiring pattern 22a formed in the second chip region CHR2 and the second final wiring pattern 22b formed in the second scribe lane region SLR2. In an embodiment, a width of the second final wiring pattern 22a may be greater than that of the second final wiring pattern 22b in an X direction. The second final wiring patterns 22a and 22b may include a metal material.

In some embodiments, the second final wiring patterns 22a and 22b may include a metal material which differs from that of a second bonding electrode 52. In one embodiment, the at least one second final wiring pattern and the second bonding electrode respectively comprises a different metal material from each other. In some embodiments, the second final wiring patterns 22a and 22b may include a base metal (e.g., aluminum and an impurity element), and for example, may include a metal alloy including silicon.

The polish stop patterns 28a and 28b may be disposed on (e.g., in the Z direction) the second final wiring patterns 22a and 22b. The polish stop patterns 28a and 28b may be formed for preventing damage to the second final wiring patterns 22a and 22b when a polishing process is performed (e.g., chemical mechanical polishing).

The polish stop patterns 28a and 28b may have at least one of a metal pattern, an insulation pattern, and a combination thereof. In some embodiments, the polish stop patterns 28a and 28b have a combination pattern of the metal patterns 24a and 24b and the insulation patterns 26a and 26b, or may be formed to have a single pattern of the metal patterns 24a and 24b and the insulation patterns 26a and 26b. In some embodiments, the metal patterns 24a and 24b may include a single layer and a combination layer of titanium (Ti), tantalum (Ta), and titanium nitride (TiN). The insulation patterns 26a and 26b may include silicon nitride.

The polish stop patterns 28a and 28b may include the polish stop pattern 28a formed in the second chip region CHR2 and the polish stop pattern 28b formed in the second scribe lane region SLR2. A width of the polish stop pattern 28a may be greater than that of the polish stop pattern 28b, in the X direction.

The second passivation layers 32a and 32b may be disposed in the first middle wiring insulation layer 14 or the second middle wiring insulation layer 18 due to an over-etching process. In an embodiment, the second passivation layers 32a and 32b may include silicon oxide. For example, the second passivation layers 32a and 32b may include silicon oxide formed by an HDP process.

The second bonding wiring layer 200e may be disposed on (e.g. disposed directly thereon in the Z direction) the second final wiring layer 200d. In an embodiment, the second bonding wiring layer 200e may include a second interlayer insulation layer 40, an adhesive layer 42, a second bonding insulation layer 44, and a second bonding electrode 52. The second interlayer insulation layer 40 may be disposed on (e.g., disposed directly thereon in the Z direction) the second passivation layers 32a and 32b and the polish stop patterns 28a and 28b.

In an embodiment, the second interlayer insulation layer 40 may include silicon nitride. The adhesive layer 42 may be formed for increasing adhesive performance between the second interlayer insulation layer 40 and the second bonding insulation layer 44. However, embodiments of the present inventive concept are not necessarily limited thereto and the adhesive layer 42 may not be formed in some embodiments. In an embodiment, the adhesive layer 42 may include silicon oxide.

The second bonding insulation layer 44 may be disposed on (e.g., disposed directly thereon in the Z direction) the second interlayer insulation layer 40 and the adhesive layer 42. In an embodiment, the second bonding insulation layer 44 may include at least one material selected from SiCN and SiO.

The second bonding electrode 52 may be disposed in the second interlayer insulation layer 40, the adhesive layer 42, the second bonding insulation layer 44, and the polish stop pattern 28a of the second chip region CHR2. The second bonding electrode 52 may include a metal material (e.g., copper, etc.). In an embodiment, the second bonding electrode 52 may have an upper width and a lower width, which differ along the Z direction. The second bonding electrode 52 includes nanotwin copper and fine grain copper. Detailed elements of the first bonding electrode 52 will be described below with reference to the drawings.

In an embodiment, each of the first bonding insulation layer 70 and the first bonding electrode 72 of the first bonding wiring layer 100d of the semiconductor chip structure 1 are hybrid-bonded to and configured in the second bonding insulation layer 44 and the second bonding electrode 52 of the second bonding wiring layer 200e. Hereinafter, a bonding configuration of the first semiconductor chip 100 and the second semiconductor chip 200 will be described in more detail with reference to an enlarged view of a cross-sectional surface of a portion EN1 of the semiconductor chip structure 1 of FIG. 2. In FIG. 2, for convenience, upper and lower widths of the first bonding electrode 72 and the second bonding electrode 52 in the Z direction are illustrated to be equal to each other. However, embodiments of the present inventive concept are not necessarily limited thereto. In one embodiment, a width (for example, in the X direction) of the first bonding electrode and a width (for example, in the X direction) of the second bonding electrode may be different from each other.

In the first semiconductor chip 100, an upper surface of each of the first final wiring pattern 65 and the first passivation layer 64 of the first final wiring layer 100c may include a first planar surface PL1 in which there is no step height between the first chip region CHR1 and the first scribe lane region SLR1. In an embodiment, the first planar surface PL1 may not have a step height by polishing (e.g., chemical mechanical polishing) a surface of each of the first final wiring pattern 65 and the first passivation layer 64.

In the first semiconductor chip 100, an upper surface of each of the first bonding electrode 72 and the first bonding insulation layer 70 of the first bonding wiring layer 100d may include a first bonding surface b1 in which there is no step height between the first chip region CHR1 and the first scribe lane region SLR1. The first bonding surface b1 may be a first planar bonding surface. The first bonding electrode 72 may have a first width W1 (e.g., length in the X direction). In an embodiment, the first bonding electrode 72 may include a first barrier metal layer 72a, a first via electrode 72b, a first internal electrode 72c, and a first upper electrode 72d.

In an embodiment, the first barrier metal layer 72a may include Ti, Ta, TiN, or TaN. The first internal electrode 72c may be electrically connected with the first via electrode 72b and may thus be provided as one body. In some embodiments, the first internal electrode 72c and the first via electrode 72b may include nanotwin copper. The first upper electrode 72d may include fine grain copper on the first internal electrode 72c. In an embodiment, the fine grain copper may have a grain size that is less than or equal to about 300 nm. In an embodiment, the fine grain copper filling the first upper electrode 72d may be about 300 nm or less in grain size (e.g., a grain length). An uppermost surface of the first upper electrode 72d may be coplanar with an uppermost surface of the first internal electrode 72c to configure a planar first bonding surface b1 in which there is no step height. The first barrier metal layer 72a, the first via electrode 72b, the first internal electrode 72c, and the first upper electrode 72d may be electrically connected with the first final wiring pattern 65.

In the second semiconductor chip 200, an upper surface of each of the polish stop patterns 28a and 28b and the second passivation layers 32a and 32b of the second final wiring layer 200d may include a second planar surface PL2 in which there is no step height between the second chip region CHR2 and the second scribe lane region SLR2.

In the second semiconductor chip 200, an upper surface of each of the second bonding electrode 52 and the second bonding insulation layer 44 of the second bonding wiring layer 200e may include a second bonding surface b2 in which there is no step height between the second chip region CHR2 and the second scribe lane region SLR2.

The second bonding surface b2 may be a second planar bonding surface. An upper portion of the second bonding electrode 52 may have a second width W2 (e.g., length in the X direction). In an embodiment, a first width W1 of an upper portion of the first bonding electrode 72 and a second width W2 of an upper portion of the second bonding electrode 52 may be substantially equal to each other. In an embodiment, the second bonding electrode 52 may include a second barrier metal layer 52a, a second via electrode 52b, a second internal electrode 52c, and a second upper electrode 52d.

In an embodiment, the second barrier metal layer 52a may include Ti, Ta, TiN, or TaN. The second internal electrode 52c may be electrically connected with the second via electrode 52b and may thus be provided as one body. In some embodiments, the second internal electrode 52c and the second via electrode 52b may include nanotwin copper. The second upper electrode 52d may include fine grain copper on the second internal electrode 52c. In an embodiment, the fine grain copper filling the second upper electrode 52d may be about 300 nm or less in grain size. An uppermost surface of the second upper electrode 52d may be coplanar with an uppermost surface of the second internal electrode 52c to configure a planar second bonding surface b2 in which there is no step height. The second barrier metal layer 52a, the second via electrode 52b, the second internal electrode 52c, and the second upper electrode 52d may be electrically connected with the second final wiring pattern 22a of the second chip region CHR2.

The first bonding surface b1 of the first bonding electrode 72 and the first bonding insulation layer 70 of the first bonding wiring layer 100d, as illustrated as an arrow of FIG. 2, may be directly bonded to the second bonding surface b2 of the second bonding electrode 52 and the second bonding insulation layer 44 of the second bonding wiring layer 200e. A simultaneous bonding of the bonding insulation layers 70 and 44 and the bonding electrodes 72 and 52 may be referred to as hybrid bonding.

In an embodiment, the hybrid bonding may be performed through thermal treatment in a state in which the first bonding insulation layer 70 and the second bonding insulation layer 44 are attached on the first and second bonding electrodes 72 and 52. The first bonding surface b1 of the first bonding wiring layer 100d and the second bonding surface b2 of the second bonding wiring layer 200e may be planar bonding surfaces. In this embodiment, interdiffusion between copper and copper may be increased (e.g., maximized) in a bonding interface which is configured by the first upper electrode 72d of the first bonding surface b1 and the second upper electrode 52d of the second bonding surface b2 each having fine grain copper. Since, the first bonding electrode 72 and the second bonding electrode 52 use a double material including fine grain copper and nanotwin copper, the semiconductor chip structure 1 may increase bonding reliability in bonding the first semiconductor chip 100 to the second semiconductor chip 200. In one embodiment, at least a portion of a bonding interface between the hybrid-bonded first bonding insulation layer and the first bonding electrode of the first bonding wiring layer to the second bonding insulation layer and the second bonding electrode of the second bonding wiring layer may comprise fine grain copper, and a remaining portion of the bonding interface and an inner portion of each of the first bonding electrode and the second bonding electrode may comprise nanotwin copper.

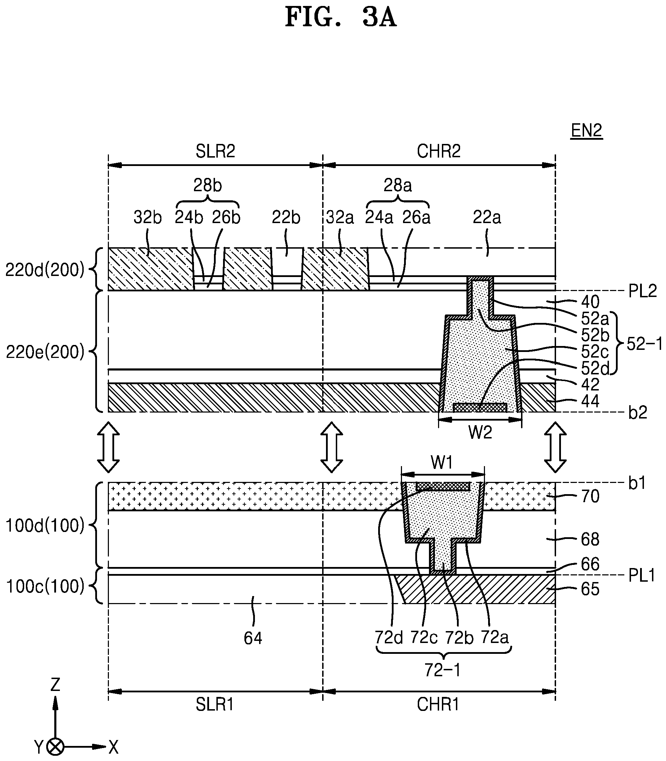

FIGS. 3A to 3C are partial cross-sectional views for describing a semiconductor chip structure according to embodiments of the present disclosure.

In detail, enlarged cross-sectional views of portions EN2 to EN4 of FIGS. 3A to 3C may be modification embodiments of an enlarged cross-sectional view of the portion EN1 of the semiconductor chip structure 1 of FIGS. 1 and 2. In FIGS. 3A to 3C, the same reference numerals as FIGS. 1 and 2 refer to like elements. In FIGS. 3A to 3C, descriptions which are the same as or similar to the descriptions of FIGS. 1 and 2 will be briefly given or are omitted for economy of description.

Referring to FIG. 3A, except for that a first bonding electrode 72-1 of a first semiconductor chip 100 and a second bonding electrode 52-1 of a second semiconductor chip 200 are bonded to each other not to match (e.g., not to completely overlap) in a Z direction (e.g., a vertical direction), an enlarged cross-sectional view of a portion EN2 of a semiconductor chip structure (1 of FIG. 1) may be the same as the enlarged cross-sectional view of the portion EN1 of the semiconductor chip structure (1 of FIG. 1) of FIG. 2. In one embodiment, at least a portion of the first portion of the first bonding electrode is hybrid-bonded to at least a portion of the second portion of the second bonding electrode.

A first bonding wiring layer 100d of the first semiconductor chip 100 may include a first bonding electrode 72-1 and a first bonding insulation layer 70. In an embodiment, the first bonding electrode 72-1, as described above, may include a first barrier metal layer 72a, a first via electrode 72b, a first internal electrode 72c, and a first upper electrode 72d. In an embodiment, a second bonding wiring layer 200e of the second semiconductor chip 200 may include a second bonding electrode 52-1 and a second bonding insulation layer 44. The second bonding electrode 52-1 may include a second barrier metal layer 52a, a second via electrode 52b, a second internal electrode 52c, and a second upper electrode 52d.

As illustrated by an arrow of FIG. 3A, the first bonding electrode 72-1 of the first semiconductor chip 100 and the second bonding electrode 52-1 of the second semiconductor chip 200 may be bonded to each other not to match in the Z direction (e.g., the vertical direction), in hybrid-bonding the first bonding wiring layer 100d to the second bonding wiring layer 200e. For example, the first bonding surface b1 and the second bonding surface b2 may not completely overlap each other (e.g., in the Z direction). Although the first bonding electrode 72-1 and the second bonding electrode 52-1 are not bonded to each other to completely match in the vertical direction, interdiffusion between copper and copper may be easily performed in a bonding interface which is formed by bonding to each other the first upper electrode 72d and the second upper electrode 52d each including a fine grain.

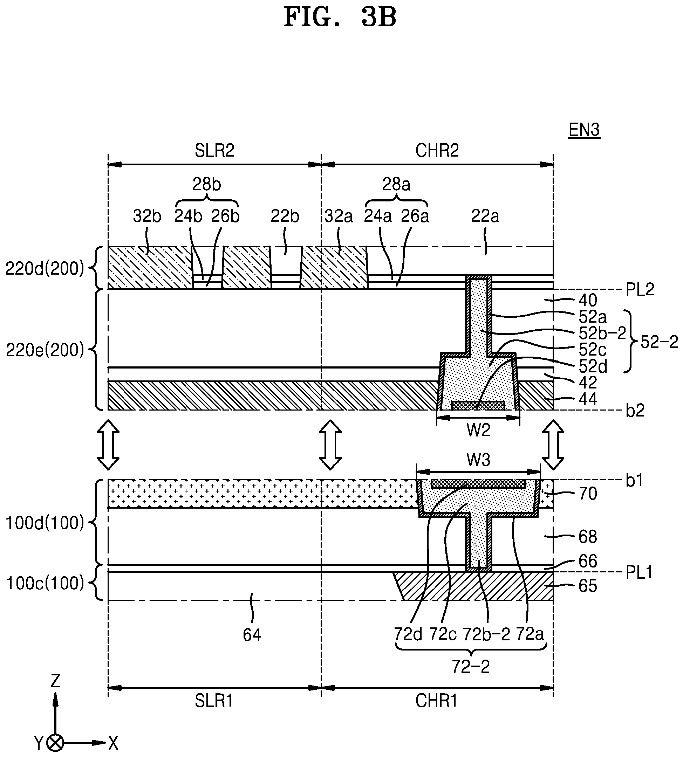

Referring to FIG. 3B, except for that a third width W3 (e.g., length in the X direction) of a first bonding electrode 72-2 and a shape of a first via electrode 72b-2 of the first bonding electrode 72-2 are changed, an enlarged cross-sectional view of a portion EN3 of a semiconductor chip structure (1 of FIG. 1) may be the same as the enlarged cross-sectional view of the portion EN2 of FIG. 3A.

In an embodiment, the third width W3 (e.g., length in the X direction) of the first bonding electrode 72-2 may be greater than a first width W1 (e.g., length in the X direction) of a first bonding electrode (72-1 of FIG. 3A). The first via electrode 72b-2 of the first bonding electrode 72-2 may be higher (e.g., have a greater length) in the Z-direction than the first via electrode 72b of FIG. 3A. The second via electrode 52b-2 of the second bonding electrode 52-2 may be higher (e.g., have a greater length) in the Z-direction height than the second via electrode 52b of FIG. 3A.

As illustrated by an arrow of FIG. 3B, the first bonding electrode 72-2 having a wide third width W3 of the first semiconductor chip 100 may be easily bonded to the second bonding electrode 52-2 having a narrower second width W2 of the second semiconductor chip 200, in hybrid-bonding the first bonding wiring layer 100d to the second bonding wiring layer 200e. The second bonding surface b2 may entirely overlap the first bonding surface b1 (e.g., in the Z direction). Although the third width W3 of the first semiconductor chip 100 is greater than the second width W2 of the second semiconductor chip 200, interdiffusion between copper and copper may be easily performed in a bonding interface which is formed by bonding, to each other, the first upper electrode 72d and the second upper electrode 52d each including a fine grain.

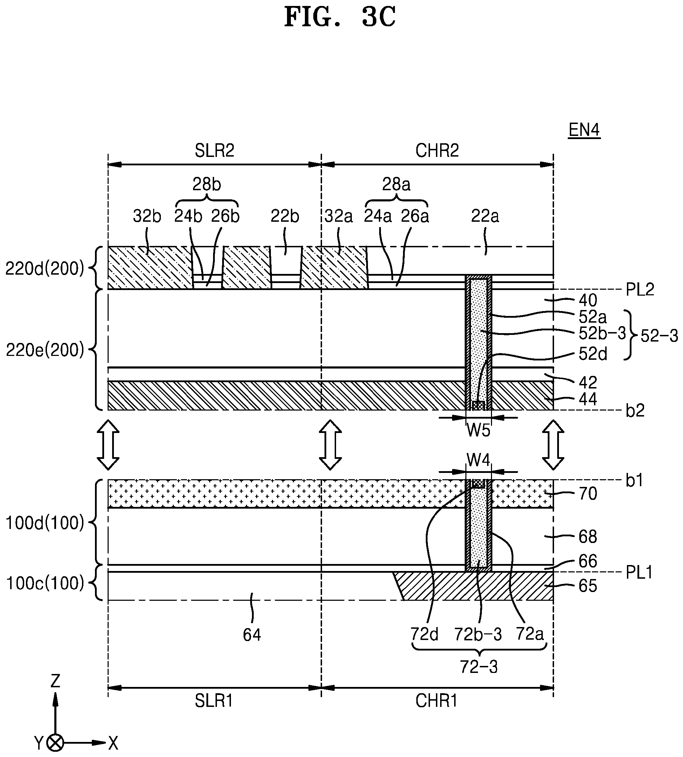

Referring to FIG. 3C, except for that a shape of a first bonding electrode 72-3 and a shape of a second bonding electrode 52-3 are changed, an enlarged cross-sectional view of a portion EN4 of a semiconductor chip structure (1 of FIG. 1) may be the same as the enlarged cross-sectional view of the portion EN2 of FIG. 3A.

In an embodiment, the first bonding electrode 72-3 may include a first barrier metal layer 72a, a first via electrode 72b-3, and a first upper electrode 72d. The first upper electrode 72d including fine grain copper may be arranged to have lateral side surfaces surrounded by the first via electrode 72b-3 including nanotwin copper. An upper surface of the first bonding electrode 72-3 may have a fourth width W4 (e.g., length in the X direction), which is less than a first width (W1 of FIG. 3A). The fourth width W4 of the first bonding electrode 72-3 may be substantially the same as or slightly less than a width of the first via electrode 72b-3.

In an embodiment, the second bonding electrode 52-3 may include a second barrier metal layer 52a, a second via electrode 52b-3, and a second upper electrode 52d. The second upper electrode 72d including fine grain copper may be arranged to have lateral side surfaces surrounded by the second via electrode 52b-3 including nanotwin copper. A fifth width W5 (e.g., length in the X direction) of the second bonding electrode 52-3 may be substantially the same as a width of the third via electrode 52b-3. The fifth width W5 of the second bonding electrode 52-3 may be substantially the same as or slightly less than the width W4 of the first bonding electrode 72-3.

As illustrated by an arrow of FIG. 3C, the first bonding electrode 72-3 having the fourth width W4 of the first semiconductor chip 100 may be easily bonded to the second bonding electrode 52-3 having the fifth width W5 of the second semiconductor chip 200, in hybrid-bonding the first bonding wiring layer 100d to the second bonding wiring layer 200e. Interdiffusion between copper and copper may be easily performed in a bonding interface which is formed by bonding, to each other, the first upper electrode 72d and the second upper electrode 52d each including a fine grain.

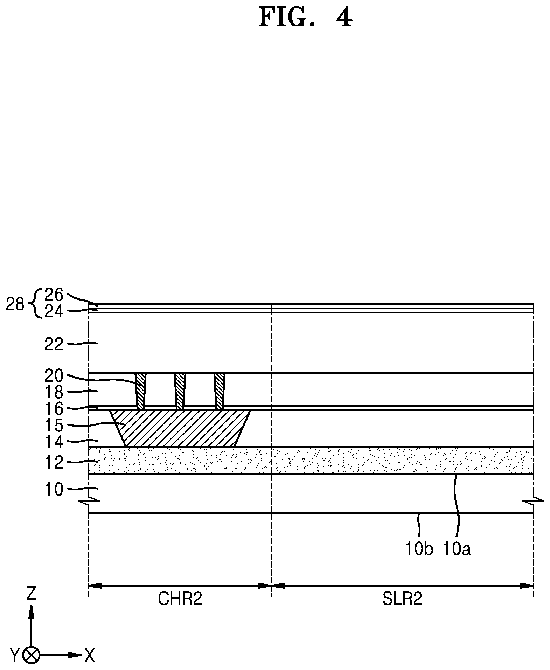

FIGS. 4 to 13 are cross-sectional views for describing a method of manufacturing the semiconductor chip structure 1 of FIGS. 1 and 2.

In detail, FIGS. 4 to 12 are diagrams for describing a method of manufacturing the second semiconductor chip 200 of FIGS. 1 and 2. In FIGS. 4 to 12, the same reference numerals as FIGS. 1 and 2 refer to like elements.

Referring to FIG. 4, a second circuit 12 may be formed on (e.g., formed directly thereon in the Z direction) a surface 10a of a second substrate 10 including a second chip region CHR2 and a second scribe lane region SLR2 that are spaced apart from each other (e.g., in the X direction). The second substrate 10 may include the surface 10a and a rear surface 10b opposite thereto. The second circuit 12, as described above, may include a memory cell. The memory cell may include circuit elements (e.g., a transistor).

A middle wiring pattern 15 insulated by a first middle wiring insulation layer 14 may be formed on (e.g., formed directly thereon in the Z direction) the second circuit 12. In an embodiment, the first middle wiring insulation layer 14 may include silicon oxide. For example, the first middle wiring insulation layer 14 may include silicon oxide formed by an HDP process. The middle wiring pattern 15 may be electrically connected with the second circuit 12. The middle wiring pattern 15 may include a metal material (e.g., aluminum, copper, tungsten, etc.).

A second etch stop layer 16 may be formed on (e.g., formed directly thereon in the Z direction) the first middle wiring insulation layer 14 and the middle wiring pattern 15. In an embodiment, the second etch stop layer 16 may include silicon nitride. A middle wiring via 20 electrically connected with the middle wiring pattern 15 and a second middle wiring insulation layer 18 insulating the middle wiring via 20 may be formed on (e.g., formed directly thereon in the Z direction) the second etch stop layer 16.

The middle wiring via 20 may include a metal material (e.g., aluminum, copper, tungsten, etc.). In an embodiment, the second middle wiring insulation layer 18 may include silicon oxide. For example, the second middle wiring insulation layer 18 may include silicon oxide formed by an HDP process.

A second final wiring material layer 22 and a polish stop material layer 28 may be sequentially formed on (e.g., in the Z direction) the second middle wiring insulation layer 18 and the middle wiring via 20. The second final wiring material layer 22 may include a metal material. For example, the second final wiring material layer 22 may include aluminum, copper, tungsten, and/or the like.

In some embodiments, the second final wiring material layer 22 may include a base metal (e.g., aluminum and an impurity element), and for example, may include a metal alloy including silicon. In an embodiment, the polish stop material layer 28 may be configured by a combination of a metal material layer 24 and an insulation material layer 26. For example, the metal material layer 24 may include a single layer or a combination layer of Ti, Ta, and TiN. The second material layer 26 may include silicon nitride.

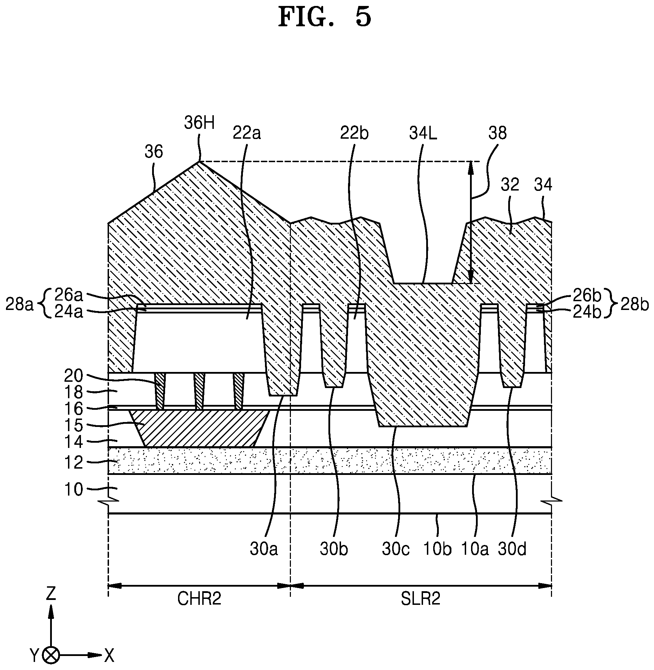

Referring to FIG. 5, in an embodiment polish stop patterns 28a and 28b and second final wiring patterns 22a and 22b may be formed by patterning the polish stop material layer 28 and the second final wiring material layer 22 by using a photolithography process.

The second final wiring patterns 22a and 22b may include the second final wiring pattern 22a formed in a second chip region CHR2 and the second final wiring pattern 22b formed in a second scribe lane region SLR2. In an embodiment, a width of the second final wiring pattern 22a may be formed to be greater than that of the second final wiring pattern 22b in an X direction. The second final wiring pattern 22b may be formed to be denser than the second final wiring pattern 22a in the X direction.

The polish stop patterns 28a and 28b may be formed on (e.g., formed directly thereon in the Z direction) the second final wiring patterns 22a and 22b. The polish stop patterns 28a and 28b may be configured by a combination of metal patterns 24a and 24b and insulation patterns 26a and 26b. The polish stop patterns 28a and 28b may include the polish stop pattern 28a formed in the second chip region CHR2 and the polish stop pattern 28b formed in the second scribe lane region SLR2. In an embodiment, an X-direction width of the polish stop pattern 28a may be greater than an X-direction width of the polish stop pattern 28b.

Due to over-etching in forming the second final wiring patterns 22a and 22b and the polish stop patterns 28a and 28b, first to fourth trenches 30a to 30d may be formed in the second middle wiring insulation layer 18. In an embodiment, a Z-direction depth of the third trench 30c formed in the second scribe lane region SLR2 may be greater than a Z-direction depth of other trenches 30a, 30b and 30d.

Subsequently, a second passivation material layer 32 may be formed on the second final wiring patterns 22a and 22b and the polish stop patterns 28a and 28b while burying the first to fourth trenches 30a to 30d. In an embodiment, the second passivation material layer 32 may include silicon oxide. For example, the second passivation material layer 32 may include silicon oxide formed by an HDP process.

The second passivation material layer 32 may include an upper surface 36 in the second chip region CHR2 and an upper surface 34 in the second scribe lane region SLR2. The second passivation material layer 32 may have a step height 38 between an uppermost (e.g. highest) surface 36H of the second chip region CHR2 and a lowermost (e.g. lowest) surface 34L of the second scribe lane region SLR2.

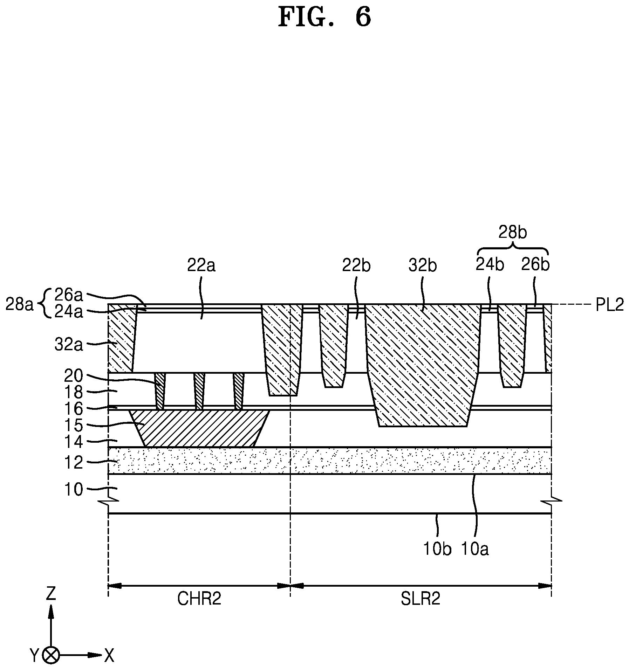

Referring to FIG. 6, the second passivation material layer 32 may be polished (e.g., chemical mechanical polishing) by using the polish stop patterns 28a and 28b as a polish stop layer. Therefore, second passivation layers 32a and 32b may be formed between structures including the second final wiring patterns 22a and 22b and the polish stop patterns 28a and 28b.

The second passivation layers 32a and 32b may include the second passivation layer 32a formed in the second chip region CHR2 and the second passivation layer 32b formed in the second scribe lane region SLR2. Also, by polishing upper surfaces of the polish stop patterns 28a and 28b and the second passivation layers 32a and 32b, a second planar surface PL2 having no step height may be formed between the second chip region CHR2 and the second scribe lane region SLR2.

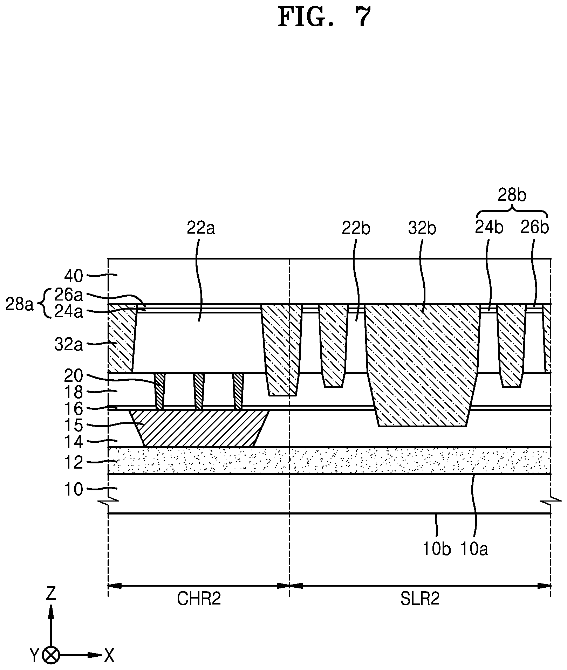

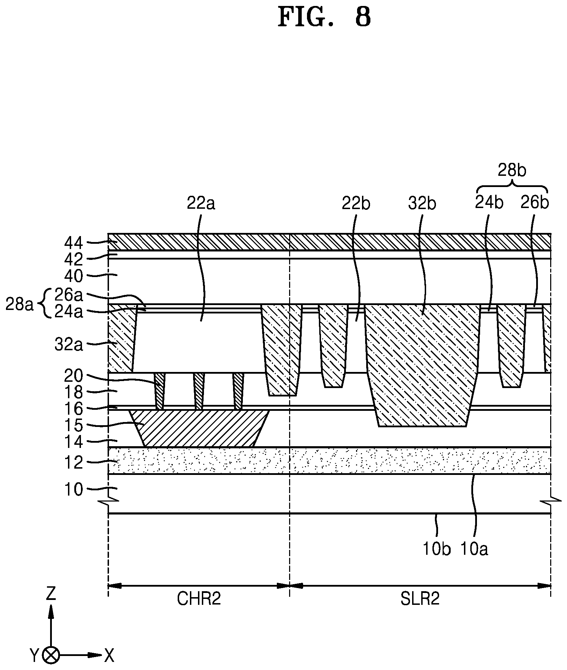

Referring to FIGS. 7 and 8, as illustrated in FIG. 7, a second interlayer insulation layer 40 may be formed on (e.g., formed directly thereon in the Z direction) the polish stop patterns 28a and 28b and the second passivation layers 32a and 32b. In an embodiment, the second interlayer insulation layer 40 may include silicon nitride. Subsequently, thermal treatment may be performed on a resulting product in which the second final wiring patterns 22a and 22b, the polish stop patterns 28a and 28b, the second passivation layers 32a and 32b, and the second interlayer insulation layer 40 are formed. For example, in an embodiment the second final wiring patterns 22a and 22b and the polish stop patterns 28a and 28b may be alloyed through a thermal treatment process.

Subsequently, as illustrated in FIG. 8, an adhesive layer 42 and a bonding insulation layer 44 may be sequentially formed on (e.g., formed directly thereon in the Z direction) the second interlayer insulation layer 40. In an embodiment, the adhesive layer 42 may be formed for increasing adhesive performance between the second interlayer insulation layer 40 and the second bonding insulation layer 44. In an embodiment, the adhesive layer 42 may include silicon oxide. The second bonding insulation layer 44 may include at least one material of SiCN and SiO.

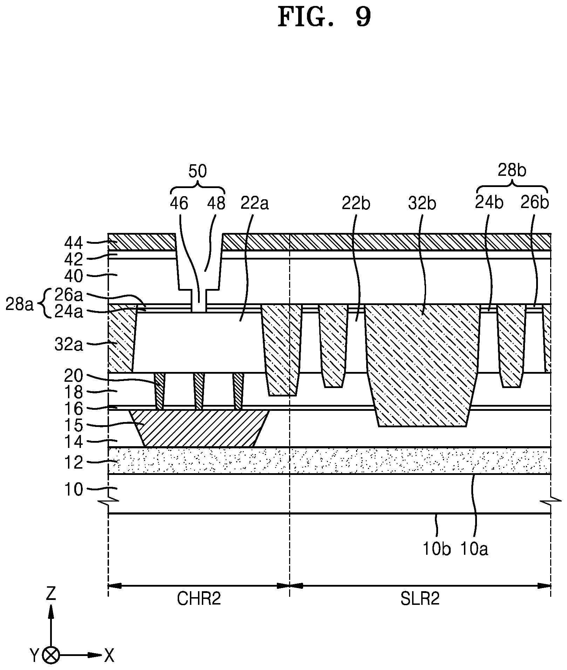

Referring to FIG. 9, in an embodiment a second via hole 50 may be formed by performing a photolithography process on the second bonding insulation layer 44, the adhesive layer 42, the second interlayer insulation layer 40, and the polish stop pattern 28a of the second chip region CHR2. The second via hole 50 may be formed in the second bonding insulation layer 44, the adhesive layer 42, the second interlayer insulation layer 40, and the polish stop pattern 28a. The second via hole 50 may expose a surface (e.g., an upper surface) of the second final wiring pattern 22a of the second chip region CHR2.

In an embodiment, the second via hole 50 may include a second lower via hole 46, formed in the second interlayer insulation layer 40 and the polish stop pattern 28a, and a second upper via hole 48 formed in the second bonding insulation layer 44, the adhesive layer 42, and the second interlayer insulation layer 40. A width of the second upper via hole 48 may be greater than that of the second lower via hole 46 in an X direction. The second upper via hole 48 may be directly connected to the second lower via hole 46.

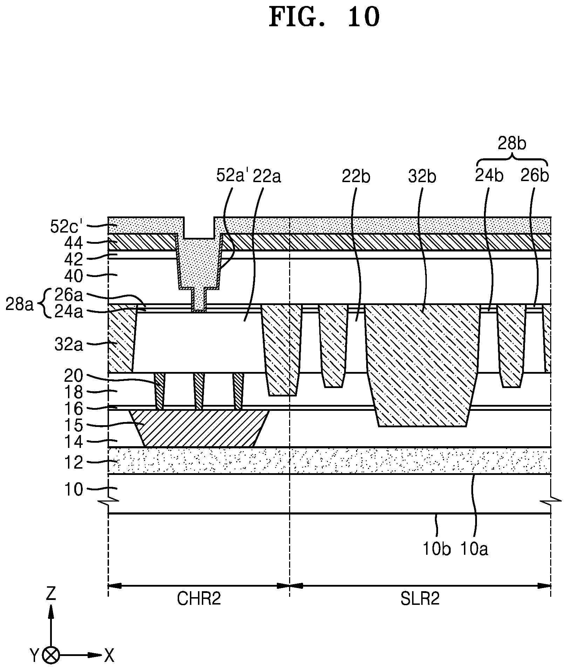

Referring to FIG. 10, in an embodiment a preliminary second barrier metal layer 52a' may be conformally deposited on a sidewall and a lower wall of the second lower via hole 46 and a sidewall of the second upper via hole 48, and a second internal electrode layer 52c' may be formed on (e.g., formed directly thereon) the preliminary second barrier metal layer 52a' and the second bonding insulation layer 44 through a plating process. The second internal electrode layer 52c' includes nanotwin copper. In an embodiment, the second internal electrode layer 52c' may be formed to completely fill the second lower via hole 46 surrounded by the preliminary second barrier metal layer 52a' and fill a portion of the second upper via hole 48. The second internal electrode layer 52c' may be formed on the second bonding insulation layer 44 to have a certain thickness. Such a process may be referred to as a first copper plating process.

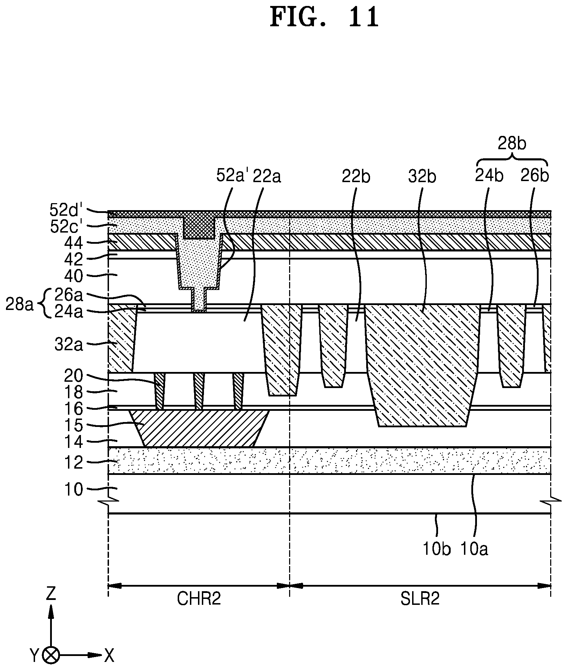

Referring to FIG. 11, a second upper electrode layer 52d' may be formed through a plating process on the resulting product of FIG. 10. The second upper electrode layer 52d' includes fine grain copper. In an embodiment, the fine grain copper filling the second upper electrode layer 52d' may be about 300 nm or less in grain size. In the second upper via hole 48, the second upper electrode layer 52d' may be formed to cover the portion in which the second internal electrode layer 52c' is not filled. The second upper electrode layer 52d' may be formed on the second internal electrode layer 52c' to cover, by a certain thickness, the second internal electrode layer 52c' formed on the second bonding insulation layer 44. Such a process may be referred to as a second copper plating process.

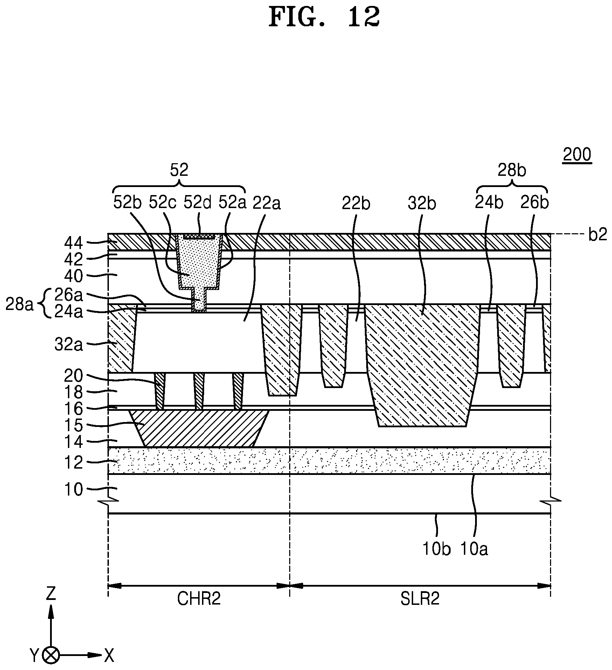

Referring to FIG. 12, in an embodiment the second upper electrode layer 52d' and the second internal electrode layer 52c' may be polished through a chemical mechanical polishing process in FIG. 11. The chemical mechanical polishing process may be performed so that an uppermost surface of the second bonding insulation layer 44 is exposed. In a resultant material of FIG. 12, a second upper electrode 52d may be formed to have a thickness (e.g. in the Z direction) in a range of about 1 µm to about 1.5 µm with respect to a second bonding surface b2. In one embodiment, the fine grain copper may have a thickness (e.g. in the Z direction) in a range of about 1 µm to about 1.5 µm with respect to the bonding interface. In an embodiment, a second barrier metal layer 52a, a second via electrode 52b, a second internal electrode 52c, and a second upper electrode 52d may configure a second bonding electrode 52. An uppermost surface of the second bonding electrode 52 may be at the same vertical level (e.g., in the Z direction) as the second bonding surface b2. When the uppermost surface of the second bonding electrode 52 is seen in a vertical direction (e.g., a Z direction), the second upper electrode 52d may not directly contact(e.g. in an X direction) an edge of the uppermost surface of the second bonding electrode 52. For example, the edge of the uppermost surface of the second bonding electrode 52 may be filled with a second internal electrode 52c. In an embodiment this may be a result which is formed by a first copper plating process and a second copper plating process, namely, copper plating processes which are divisionally performed twice. In one embodiment, the fine grain copper may not be disposed at an edge of an uppermost surface of the first bonding electrode and an edge of an uppermost surface of the second bonding electrode. In one embodiment, the first bonding electrode may comprise a first portion having an uppermost surface plated with fine grain copper, and nanotwin copper surrounding a side surface of the first portion and filling an inner portion of the first bonding electrode. In one embodiment, the second bonding electrode may comprise a second portion having an uppermost surface plated with fine grain copper, and nanotwin copper surrounding a side surface of the second portion and filling an inner portion of the second bonding electrode.

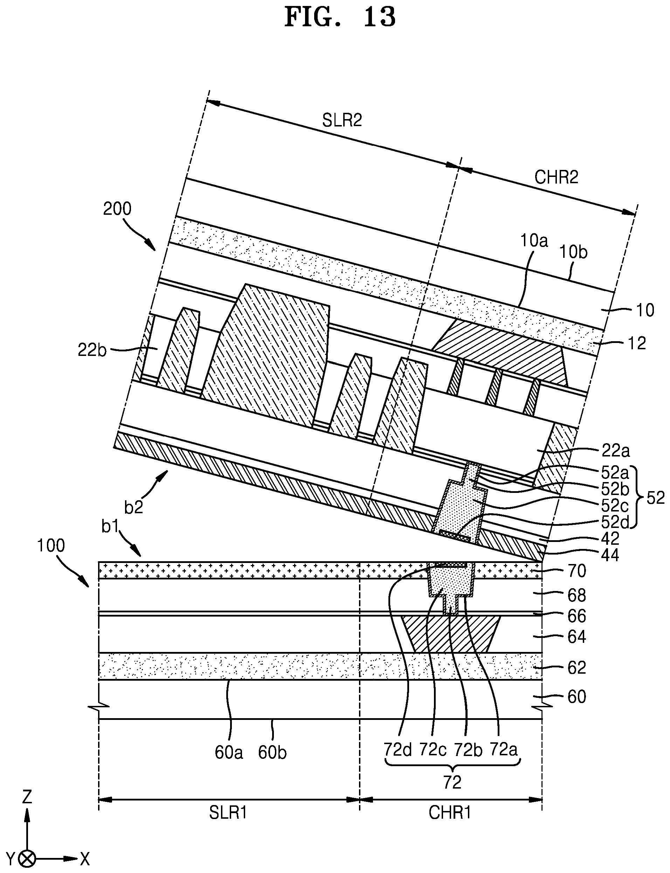

Referring to FIG. 13, FIG. 13 is a diagram for describing a bonding process of the first semiconductor chip 100 and the second semiconductor chip 200 of FIGS. 1 and 2. The first semiconductor chip 100 illustrated in FIGS. 1 and 2 may be prepared. In FIG. 13, the same reference numerals as FIGS. 1 and 2 refer to like elements. In FIG. 13, descriptions which are the same as or similar to the descriptions of FIGS. 1 and 2 will be briefly given or are omitted.

In the first semiconductor chip 100, a first circuit 62 may be formed on (e.g., formed directly thereon in the Z direction) a first substrate 60, and then, a first passivation layer 64 and a first final wiring pattern (not shown here) may be formed on the first circuit 62 (e.g., in the Z direction). A first etch stop layer 66 may be formed on (e.g., formed directly thereon in the Z direction) the first passivation layer 64 and the first final wiring pattern 65. A first interlayer insulation layer 68 and a first bonding insulation layer 70 may be formed on (e.g., formed directly thereon in the Z direction) the first etch stop layer 66.

A first bonding electrode 72 electrically connected with the first final wiring pattern 65 may be formed on the first etch stop layer 66 and in the first interlayer insulation layer 68 and the first bonding insulation layer 70. In an embodiment, the first bonding insulation layer 70 may include at least one material selected from SiCN and SiO. The first bonding electrode 72 may include a metal material (e.g., copper). In an embodiment, a first via electrode 72b and a first internal electrode 72c of the first bonding electrode 72 may include nanotwin copper, and the first upper electrode 72d may include fine grain copper.

An upper surface of each of the first bonding electrode 72 and the first bonding insulation layer 70 may be a first bonding surface b1 in which there is no step height between the first chip region CHR1 and the first scribe lane region SLR1. The first bonding surface b1 may be a first planar bonding surface. Through such a manufacturing process, the first semiconductor chip 100 may be manufactured.

The second semiconductor chip 200 manufactured as illustrated in FIG. 13 may be reversed (e.g. turned upside down) and disposed on the first semiconductor chip 100. The second bonding electrode 52 including the second bonding surface b2 and the second bonding insulation layer 44 are respectively hybrid-bonded to the first bonding electrode 72 including the first bonding surface b1 and the first bonding insulation layer 70. In this embodiment, interdiffusion between copper and copper may be increased in a bonding interface which is configured by the first upper electrode 72d of the first bonding surface b1 and the second upper electrode 52d of the second bonding surface b2 each having fine grain copper. Since the first bonding electrode 72 and the second bonding electrode 52 use a double material including fine grain copper and nanotwin copper, the semiconductor chip structure 1 may increase bonding reliability in bonding the first semiconductor chip 100 to the second semiconductor chip 200.

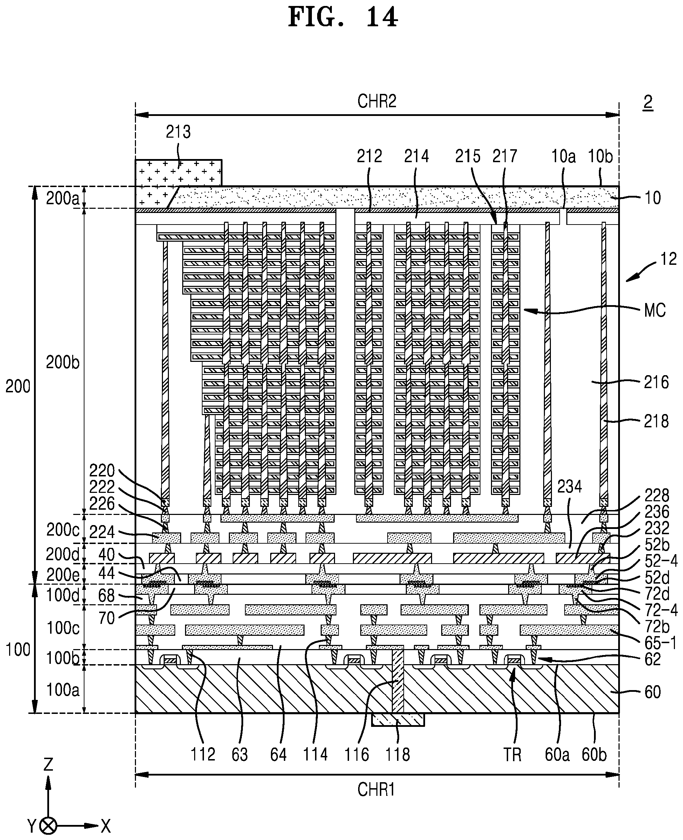

FIG. 14 is a cross-sectional view for describing a semiconductor chip structure 2 according to an embodiment.

In detail, in FIG. 14, an X direction and a Y direction are each a direction parallel to a surface 60a (e.g., an upper surface) of a first substrate 60 and a surface 10a of a second substrate 10. In an embodiment, a Z direction may be a direction perpendicular to the surface 60a (e.g., an upper surface) of the first substrate 60 and the surface 10a of the second substrate 10.

The semiconductor chip structure 2 may be configured by bonding the second semiconductor chip 200 to the first semiconductor chip 100. The first semiconductor chip 100 may include a first chip region CHR1. The first chip region CHR1 may be a region where circuit elements (e.g., a transistor TR) configuring the first semiconductor chip 100 are provided. The first chip region CHR1 may be a region where a peripheral circuit is formed.

The second semiconductor chip 200 may include a second chip region CHR2. The second chip region CHR2 may be a region where circuit elements (e.g., a memory cell) configuring the second semiconductor chip 200 are provided.

In an embodiment, the semiconductor chip structure 2 may be configured by the second semiconductor chip 200 including the second chip region CHR2 to the first semiconductor chip 100 including the first chip region CHR1. In FIG. 14, unlike FIG. 1, for convenience, the semiconductor chip structure 2 may not include a first scribe lane region SLR1 of the first semiconductor chip 100 and a second scribe lane region SLR2 of the second semiconductor chip 200.

First, elements of the first semiconductor chip 100 and the second semiconductor chip 200 will be described in more detail.

In an embodiment, the first semiconductor chip 100 may include a first substrate layer 100a, a first circuit layer 100b, a first final wiring layer 100c, and a first bonding wiring layer 100d. The first substrate layer 100a may include a first substrate 60.

The first substrate 60 may include the surface 60a and a rear surface 60b disposed at a side opposite to the surface 60a (e.g., in the Z direction). In an embodiment, the first substrate 60 may be a silicon substrate. The first substrate 60 may be a silicon wafer. The first substrate 60 may include the first chip region CHR1.

The first circuit layer 100b may be disposed on (e.g., disposed directly thereon in the Z direction) the first substrate layer 100a. The first circuit layer 100b may be disposed on the first substrate 60 including the first chip region CHR1. In an embodiment, the first circuit layer 100b may include a first circuit 62 and a first circuit insulation layer 63 insulating the first circuit 62. The first circuit 62 may be disposed on the surface 60a of the first substrate 60. The first circuit 62 may be a peripheral circuit. In an embodiment, the peripheral circuit may include a transistor TR and a contact plug 112.

The first final wiring layer 100c may be disposed on (e.g., disposed directly thereon in the Z direction) the first circuit layer 100b. In an embodiment, the first final wiring layer 100c may include a first final wiring pattern 65-1, a first final wiring via 114, and a first passivation layer 64 insulating the first final wiring pattern 65-1.

The first final wiring pattern 65-1 may be electrically connected with the first circuit 62. In FIG. 14, the first final wiring pattern 65-1 is illustrated as being directly connected with the first circuit 62. However, embodiments of the present inventive concept are not necessarily limited thereto and the first final wiring pattern 65-1 may be electrically connected with the first circuit 62 through a middle wiring pattern. The first final wiring pattern 65-1 may include a metal material.

The first final wiring pattern 65-1 may be electrically connected with a first external connection terminal 118 disposed on the rear surface 60b of the substrate 60. In an embodiment, the first final wiring pattern 65-1 may be electrically connected with the first external connection terminal 118 through a through via 116 passing through the first circuit insulation layer 63 and the first substrate 60. However, embodiments of the present inventive concept are not necessarily limited thereto and the first external connection terminal 118 may not be formed in some embodiments.

In some embodiments, the first final wiring pattern 65-1 may include a metal material which differs from that of a first bonding electrode 72-4. In some embodiments, the first final wiring pattern 65-1 may include aluminum, copper, tungsten, and/or the like. In some embodiments, the first final wiring pattern 65-1 may include a base metal (e.g., aluminum and an impurity element), and for example, may include a metal alloy including silicon.

The first passivation layer 64 may insulate the first final wiring pattern 65-1. In an embodiment, the first passivation layer 64 may include silicon oxide. For example, the first passivation layer 64 may include silicon oxide formed by an HDP process.

The first bonding wiring layer 100d may be disposed on (e.g., disposed directly thereon in the Z direction) the first final wiring layer 100c. In an embodiment, the first bonding wiring layer 100d may include a first interlayer insulation layer 68, a first bonding insulation layer 70, and the first bonding electrode 72-4. The first bonding electrode 72-4 may include a first via electrode 72b, a first internal electrode 72c, and a first upper electrode 72d. The first interlayer insulation layer 68 may be disposed on the first passivation layer 64 and the first final wiring pattern 65-1. In an embodiment, the first interlayer insulation layer 68 may include silicon oxide. For example, the first interlayer insulation layer 68 may include silicon oxide formed by an HDP process.

The first bonding insulation layer 70 may be disposed on (e.g., disposed directly thereon in the Z direction) the first interlayer insulation layer 68. In an embodiment, the first bonding insulation layer 70 may include at least one material selected from SiCN and SiO. The first via electrode 72b may be disposed in the first interlayer insulation layer 68. In an embodiment, the first internal electrode 72c may be electrically connected with the first via electrode 72b and may be provided as one body, on the first via electrode 72b. The first internal electrode 72c may be disposed in the first bonding insulation layer 70.

The first via electrode 72b, the first internal electrode 72c, and the first upper electrode 72d may include a metal material (e.g., copper, etc.). The first via electrode 72b and the first internal electrode 72c may include nanotwin copper. The first upper electrode 72d disposed on the first internal electrode 72c may include fine grain copper.

In an embodiment, the second semiconductor chip 200 may include a second substrate layer 200a, a second circuit layer 200b, a middle wiring layer 200c, a second final wiring layer 200d, and a second bonding wiring layer 200e. The second substrate layer 200a may include a second substrate 10. The second substrate 10 may include a surface 10a and a rear surface 10b disposed at a side opposite to the surface 10a (e.g., in the Z direction). In an embodiment, the second substrate 10 may be a silicon substrate. The second substrate 10 may be a silicon wafer. The second substrate 10 may include the second chip region CHR2.

The second circuit layer 200b may be disposed on (e.g., disposed directly thereon in the Z direction) the second substrate 10 including the second chip region CHR2. The second circuit layer 200b may include a second circuit 12. The second circuit 12 may be disposed on the surface 10a of the second substrate 10. The second circuit 12 may be driven by the first circuit 62. A second external connection terminal 213 connected with the second circuit 12 may be disposed on the rear surface 10b of the second substrate 10. However, embodiments of the present inventive concept are not necessarily limited thereto and the second external connection terminal 213 may not be formed in some embodiments.

In an embodiment, the second circuit 12 may include a memory cell MC. In an embodiment, the memory cell MC may include conductive layers 212 and 214 of the second substrate 10 and a stack structure 215 and a channel structure 217 each disposed on the conductive layers 212 and 214. The second circuit 12 may include a second circuit insulation layer 216, a contact plug 218, a pad 220, and a via plug 222.

The middle wiring layer 200c may be disposed on (e.g., disposed directly thereon in the Z direction) the second circuit layer 200b. In an embodiment, the middle wiring layer 200c may include a middle wiring insulation layer 228, a middle wiring pattern 224, and a middle wiring via 226. The middle wiring pattern 224 may be electrically connected with the via plug 222 of the second circuit 12.

The middle wiring pattern 224 and the middle wiring via 226 may be insulated by the middle wiring insulation layer 228. The middle wiring pattern 224 and the middle wiring via 226 may include a metal material (e.g., aluminum, copper, tungsten, etc.). In an embodiment, the middle wiring insulation layer 228 may include silicon oxide. The middle wiring insulation layer 228 may be silicon oxide.

The second final wiring layer 200d may be disposed on (e.g., disposed directly thereon in the Z direction) the middle circuit layer 200c. The second final wiring layer 200d may include a second final wiring pattern 236, a second passivation layer 234, and a second final wiring via 232. The second final wiring pattern 236 may be electrically connected with the middle wiring pattern 224 through the second final wiring via 232.

In some embodiments, the second final wiring pattern 236 may include a metal material which differs from that of a second bonding electrode 52-4. For example, in some embodiments, the second final wiring pattern 236 may include aluminum, copper, tungsten, and/or the like. In some embodiments, the second final wiring pattern 236 may include a base metal (e.g., aluminum and an impurity element), and for example, may include a metal alloy including silicon.

In an embodiment, the second passivation layer 234 may include silicon oxide. The second passivation layer 234 may be silicon oxide.

The second bonding wiring layer 200e may be disposed on (e.g., disposed directly thereon in the Z direction) the second final wiring layer 200d. In an embodiment, the second bonding wiring layer 200e may include a second interlayer insulation layer 40, a second bonding insulation layer 44, and the second bonding electrode 52-4. The second bonding electrode 52-4 may include a second via electrode 52b, a second internal electrode 52c, and a second upper electrode 52d. The second interlayer insulation layer 40 may be disposed on (e.g., formed directly thereon in the Z direction) the second passivation layer 234.

In an embodiment, the second interlayer insulation layer 40 may include silicon nitride. The second bonding insulation layer 44 may be disposed on the second interlayer insulation layer 40. In an embodiment, the second bonding insulation layer 44 may include at least one material selected from SiCN and SiO.

The second bonding electrode 52-4 may be disposed in the second bonding insulation layer 44. The second via electrode 52b may be disposed in the second interlayer insulation layer 40. The second via electrode 52b, the second internal electrode 52c, and the second upper electrode 52d may include a metal material (e.g., copper, etc.). The second via electrode 52b and the second internal electrode 52c may include nanotwin copper. The second upper electrode 52d disposed on the second internal electrode 52c may include fine grain copper.

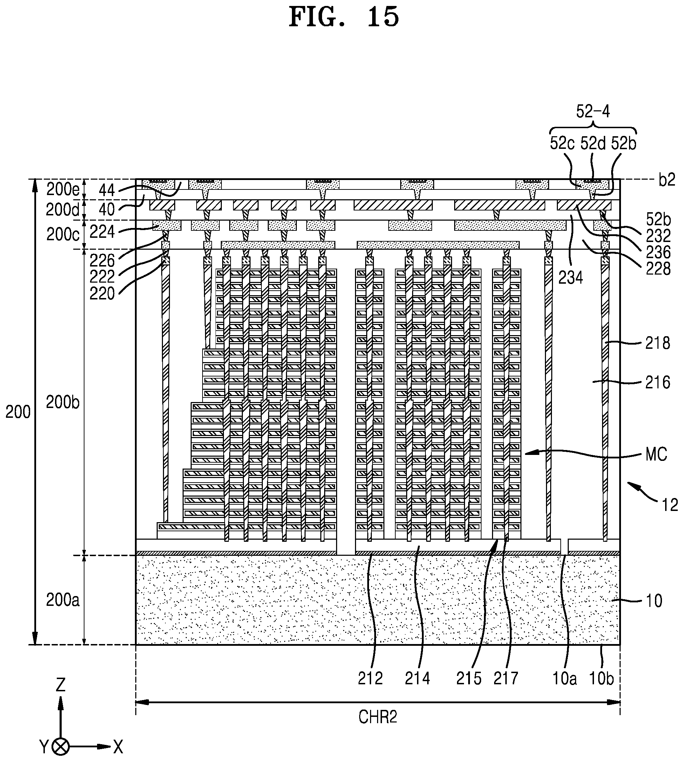

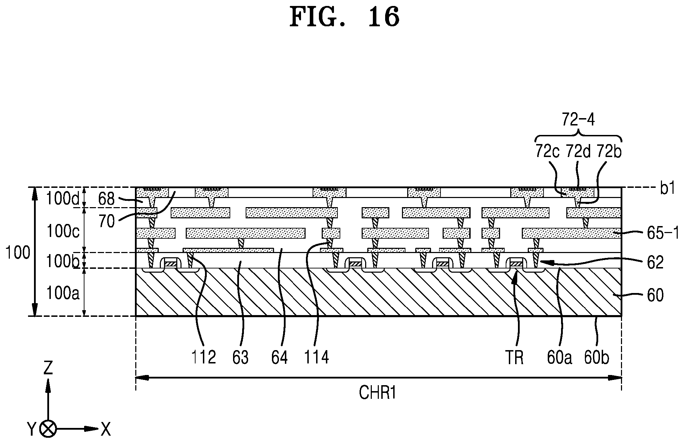

FIGS. 15 and 16 are cross-sectional views for describing a method of manufacturing a semiconductor chip structure, according to embodiments of the present inventive concept.

In detail, FIG. 15 is a diagram for describing a method of manufacturing the second semiconductor chip 200 of FIG. 14. In FIG. 15, the same reference numerals as FIG. 14 refer to like elements.

Referring to FIG. 15, a second semiconductor chip 200 may include a second substrate layer 200a. The second substrate layer 200a may be formed on a second substrate 10 including a second chip region CHR2.

A second circuit layer 200b may be formed on (e.g., formed directly thereon in the Z direction) the second substrate layer 200a. The second circuit layer 200b may include a second circuit 12. The second circuit 12 may be formed on a surface 10a (e.g., an upper surface) of the second substrate 10 including the second chip region CHR2.

In an embodiment, the second circuit 12 may include a memory cell MC. The memory cell MC may include conductive layers 212 and 214 of the second substrate 10 and a stack structure 215 and a channel structure 217 each disposed on the conductive layers 212 and 214.

In an embodiment, the stack structure 215 may include a gate pattern, a dielectric layer, and an insulation layer. The dielectric layer may cover an upper surface and a lower surface of the gate pattern and may extend to one side surface. In an embodiment, the dielectric layer may include a high-k dielectric such as aluminum oxide. A plurality of gate patterns may be stacked to be spaced apart from one another by the insulation layer in a vertical direction (e.g., the Z direction).

In an embodiment, the channel structure 217 may include a channel semiconductor layer (not shown), a vertical insulation layer (not shown) formed inward from the channel semiconductor layer, and a gate dielectric structure (not shown) disposed between the channel semiconductor layer and the stack structure 215. In an embodiment, the gate dielectric structure may include a tunnel dielectric layer, an information storage layer, and a blocking dielectric layer.

In an embodiment, the tunnel dielectric layer may include silicon oxide and/or impurity-doped silicon oxide. The blocking dielectric layer may include silicon oxide and/or a high-k dielectric. The information storage layer may include a material for storing information, and for example, may include silicon nitride.

Furthermore, in an embodiment the second circuit 12 may include a contact plug 218 formed on the conductive layers 212 and 214, a pad 220 formed on the channel structure 217 and the contact plug 218, and a via plug 222 formed on the pad 220. The conductive layers 212 and 214, the contact plug 218, the pad 220, and the via plug 222 may be insulated by the second circuit insulation layer 216.

A middle wiring layer 200c may be formed on (e.g., formed directly thereon in the Z direction) the second circuit layer 200b. In an embodiment, the middle wiring layer 200c, as described above, may include a middle wiring insulation layer 228, a middle wiring pattern 224, and a middle wiring via 226. The middle wiring pattern 224 may be electrically connected with the via plug 222 of the second circuit 12.

A second final wiring layer 200d may be formed on (e.g., formed directly thereon in the Z direction) the middle wiring layer 200c. In an embodiment, the second final wiring layer 200d, as described above, may include a second final wiring pattern 236, a second passivation layer 234, and a second final wiring via 232. The second final wiring pattern 236 may be electrically connected with the middle wiring pattern 224 through the second final wiring via 232.

A second bonding wiring layer 200e may be formed on (e.g., formed directly thereon in the Z direction) the second final wiring layer 200d. The second bonding wiring layer 200e, as described above, may include a second interlayer insulation layer 40, a second bonding insulation layer 44, and the second bonding electrode 52-4. The second bonding electrode 52-4 may include a second via electrode 52b, a second internal electrode 52c, and a second upper electrode 52d.

An upper surface of each of the second bonding electrode 52-4 and the second bonding insulation layer 44 may be a second bonding surface b2. The second bonding surface b2 may be a second planar bonding surface. Through such a manufacturing process, the second semiconductor chip 200 of FIG. 14 may be manufactured.

Referring to FIG. 16, the first semiconductor chip 100 illustrated in FIG. 14 may be prepared. In FIG. 16, the same reference numerals as FIG. 14 refer to like elements. In FIG. 16, descriptions which are the same as or similar to the descriptions of FIGS. 1 and 2 will be briefly given or are omitted for economy of description.

The first semiconductor chip 100 may include a first substrate layer 100a. The first substrate layer 100a may include a first substrate 60. A first circuit layer 100b may be formed on (e.g., formed directly thereon in the Z direction) the first substrate layer 100a. In an embodiment, the first circuit layer 100b may include a first circuit 62 and a first circuit insulation layer 63 insulating the first circuit 62. The first circuit 62 may be a peripheral circuit. In an embodiment, the peripheral circuit may include a transistor TR and a contact plug 112.

A first final wiring layer 100c may be formed on (e.g., formed directly thereon in the Z direction) the first circuit layer 100b. In an embodiment, the first final wiring layer 100c, as described above, may include a first passivation layer 64 and a first final wiring pattern 65-1.

A first bonding wiring layer 100d may be formed on (e.g., formed directly thereon in the Z direction) the first final wiring layer 100c. In an embodiment, the first bonding wiring layer 100d, as described above, may include a first interlayer insulation layer 68, a first bonding insulation layer 70, and a first bonding electrode 72-4. The first bonding electrode 72-4 may include a first via electrode 72b, a first internal electrode 72c, and a first upper electrode 72d. The first via electrode 72b and the first internal electrode 72c may include nanotwin copper. The first upper electrode 72d formed on the first internal electrode 72c may include fine grain copper.

An upper surface of each of the first bonding electrode 72-4 and the first bonding insulation layer 70 may be a first bonding surface b1. The first bonding surface b1 may be a first planar bonding surface. Through such a manufacturing process, the first semiconductor chip 100 may be manufactured.

Subsequently, the second semiconductor chip 200 of FIG. 15 manufactured above may be reversed (e.g. turned upside down) and disposed on the first semiconductor chip 100. The second bonding electrode 52-4 including the second bonding surface b2 and the second bonding insulation layer 44 may be respectively hybrid-bonded to the first bonding electrode 72-4 including the first bonding surface b1 and the first bonding insulation layer 70. In this embodiment, interdiffusion between copper and copper may be increased in a bonding interface which is configured by the first upper electrode 72d of the first bonding surface b1 and the second upper electrode 52d of the second bonding surface b2 each having fine grain copper. Since the first bonding electrode 72 and the second bonding electrode 52 use a double material including fine grain copper and nanotwin copper, the semiconductor chip structure 2 may increase bonding reliability in bonding the first semiconductor chip 100 to the second semiconductor chip 200.

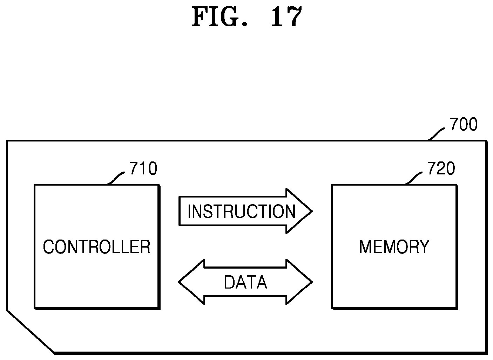

FIG. 17 is a block diagram schematically illustrating a memory card 700 to which a semiconductor package including a semiconductor chip structure according to an embodiment is applied.

Referring to FIG. 17, in detail, a controller 710 and a memory 720 may be provided to exchange an electrical signal, in the memory card 700. For example, when the controller 710 issues an instruction, the memory 720 may transfer data. In an embodiment, the controller 710 and/or the memory 720 may include a semiconductor package to which a semiconductor chip structure according to one of described embodiments is applied. An example of the semiconductor package may be as described above with reference to FIGS. 14 and 15. In an embodiment, the memory 720 may include a memory array or a memory array bank.

In an embodiment, the memory card 700 may be used in various kinds of cards (e.g., a memory stick card, a smart media card (SM), a secure digital (SD), and a mini secure digital card (mini SD)), or a memory device such as a multimedia card (MMC).

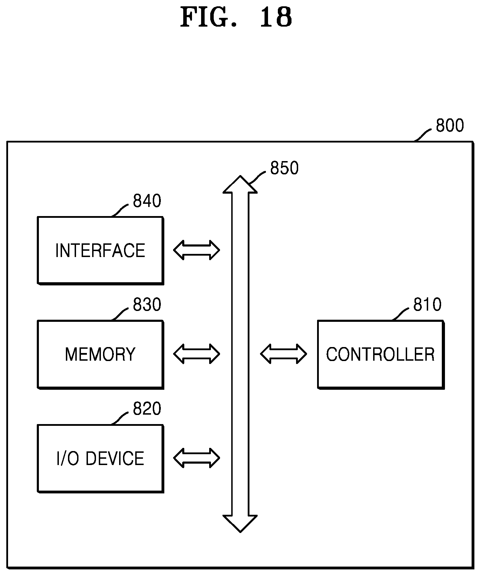

FIG. 18 is a block diagram schematically illustrating an electronic system 800 to which a semiconductor package including a semiconductor chip structure according to an embodiment is applied.

Referring to FIG. 18, in detail, in an embodiment the electronic system 800 may include a controller 810, an input/output (I/O) device 820, a memory 830, and an interface 840. In an embodiment, the electronic system 800 may be a mobile system or a system which transfers or receives information. For example, the mobile system may be a personal digital assistant (PDA), a portable computer, a web tablet, a wireless phone, a mobile phone, a digital music player, or a memory card. However, embodiments of the present inventive concept are not necessarily limited thereto.

The controller 810 may execute a program and may control the electronic system 800. In an embodiment, the controller 810 may be, for example, a microprocessor, a digital signal processor, a microcontroller, or a device similar thereto. However, embodiments of the present inventive concept are not necessarily limited thereto. The I/O device 820 may be used in inputting or outputting data of the electronic system 800.

The electronic system 800 may be connected with (e.g., electrically connected therewith) an external device (e.g., a personal computer or a network) by using the I/O device 820 and may exchange data with the external device. The I/O device 820 may be, for example, a keypad, a keyboard, or a display. The memory 830 may store a code and/or data for an operation of the controller 810, and/or may store data obtained through processing by the controller 810.

The controller 810 and/or the memory 830 may include a semiconductor package to which a semiconductor chip structure according to one of described embodiments is applied. An example of the semiconductor package may be as described above with reference to FIGS. 14 and 15. The interface 840 may be a data transmission path between the electronic system 800 and another external device. The controller 810, the I/O device 820, the memory 830, and the interface 840 may communicate with one another through a bus 850.

For example, in an embodiment the electronic system 800 may be used in a mobile phone, an MP3 player, a navigation device, a portable multimedia player (PMP), a solid state disk (SSD), or household appliances. However, embodiments of the present inventive concept are not necessarily limited thereto.

Hereinabove, non-limiting embodiments have been described in the drawings and the specification. Embodiments have been described by using the terms described herein, but this has been merely used for describing the present inventive concept and has not been used for limiting a meaning or limiting the scope of the present inventive concept defined in the following claims. Therefore, it may be understood by those of ordinary skill in the art that embodiments of the present inventive concept, as defined by the claims, may include various modifications and other equivalents from the described embodiments.

## Claims

1. A semiconductor chip structure (1) having a first semiconductor chip (100) including a first chip region (CHR1) and a first scribe lane region (SLR1), the first semiconductor chip being bonded to a second semiconductor chip (200) including a second chip region (CHR2) and a second scribe lane region (SLR2) respectively corresponding to the first chip region and the first scribe lane region,
wherein the first semiconductor chip comprises:
a first final wiring layer (100c) including a first final wiring pattern (65) and a first passivation layer (64) insulating the first final wiring pattern; and
a first bonding wiring layer (100d) disposed on the first final wiring layer, the first bonding wiring layer including a first bonding insulation layer (70) and a first bonding electrode (72) disposed in the first bonding insulation layer,
the second semiconductor chip comprises:
a second final wiring layer (200d) including at least one second final wiring pattern (22a, 22b), a polish stop pattern (28a, 28b) disposed on the at least one second final wiring pattern, and a second passivation layer (32a, 32b) insulating the at least one second final wiring pattern and the polish stop pattern; and
a second bonding wiring layer (200e) disposed on the second final wiring layer, the second bonding wiring layer including a second bonding insulation layer (44) and a second bonding electrode (52) disposed in the second bonding insulation layer and the polish stop pattern,
wherein the first bonding insulation layer and the first bonding electrode of the first bonding wiring layer are respectively hybrid-bonded to the second bonding insulation layer and the second bonding electrode of the second bonding wiring layer, and
at least a portion of a bonding interface between the hybrid-bonded first bonding insulation layer and the first bonding electrode of the first bonding wiring layer to the second bonding insulation layer and the second bonding electrode of the second bonding wiring layer comprises fine grain copper, and a remaining portion of the bonding interface and an inner portion of each of the first bonding electrode and the second bonding electrode comprise nanotwin copper;
**characterized in that**
the fine grain copper is not disposed at an edge of an uppermost surface of the first bonding electrode and an edge of an uppermost surface of the second bonding electrode.

2. The semiconductor chip structure of claim 1, wherein the fine grain copper has a thickness in a range of about 1 µm to about 1.5 µm with respect to the bonding interface.

3. The semiconductor chip structure of claim 1 or 2, wherein the fine grain copper has a grain size that is less than or equal to about 300 nm.

4. The semiconductor chip structure of any preceding claim, wherein:
a surface of each of the first final wiring pattern (65) and the first passivation layer (64) is a first planar surface that does not have a step height between the first chip region and the first scribe lane region; and
a surface of each of the second final wiring pattern (22a, 22b) and the second passivation layer (32a, 32b) is a second planar surface that does not have a step height between the second chip region and the second scribe lane region.

5. The semiconductor chip structure of any preceding claim, wherein the first bonding insulation layer (70) and the second bonding insulation layer (44) comprise at least one compound selected from silicon carbide nitride and silicon oxide.

6. The semiconductor chip structure of any preceding claim, wherein:
the first bonding electrode (72) is electrically connected with the first final wiring pattern (65); and
the second bonding electrode (52) is electrically connected with at least one of the at least one second final wiring patterns (22a, 22b).

7. The semiconductor chip structure of any preceding claim, wherein an etch stop layer (66) is disposed on the first final wiring pattern (65) and the first passivation layer (64).

8. The semiconductor chip structure of any preceding claim, wherein:
the first final wiring pattern (65) and the first bonding electrode (72) respectively comprise a different metal material from each other; and
the at least one second final wiring pattern (22a, 22b) and the second bonding electrode (52) respectively comprises a different metal material from each other.

9. The semiconductor chip structure of any preceding claim, wherein a width of the first bonding electrode (72) and a width of the second bonding electrode (52) are different from each other.

10. The semiconductor chip structure of claim 1,
wherein the first semiconductor chip (100) comprises:
a first circuit layer (100b) disposed in the first chip region and the first scribe lane region, wherein the first final wiring layer is disposed on the first circuit layer; and
wherein the first bonding wiring layer includes a first interlayer insulation layer (68), the first bonding insulation layer being disposed on the first interlayer insulation layer, and the first bonding electrode being disposed in the first interlayer insulation layer and the first bonding insulation layer,
wherein the second semiconductor chip comprises:
a second circuit layer (200b) disposed in the second chip region and the second scribe lane region, wherein the second final wiring layer is disposed on the second circuit layer; and
wherein the second bonding wiring layer includes a second interlayer insulation layer (40), the second bonding insulation layer being disposed on the second interlayer insulation layer, and the second bonding electrode being disposed in the second bonding insulation layer, the second interlayer insulation layer, and the polish stop pattern;
wherein the first bonding electrode comprises a first portion having the uppermost surface plated with fine grain copper, and nanotwin copper surrounding a side surface of the first portion and filling the inner portion of the first bonding electrode; and
wherein the second bonding electrode comprises a second portion having the uppermost surface plated with fine grain copper, and nanotwin copper surrounding a side surface of the second portion and filling the inner portion of the second bonding electrode.

11. The semiconductor chip structure of claim 10, wherein at least a portion of the first portion is hybrid-bonded to at least a portion of the second portion.

12. The semiconductor chip structure of claim 10 or 11, wherein the fine grain copper is formed to have a thickness in a range of about 1 µm to about 1.5 µm with respect to an uppermost surface of the first bonding electrode or the second bonding electrode.

13. The semiconductor chip structure of any one of claims 10 to 12, wherein the fine grain copper has a grain size that is less than or equal to about 300 nm.

14. The semiconductor chip structure of any one of claims 10 to 13, wherein the first circuit layer comprises a peripheral circuit (62), and the second circuit layer comprises a memory cell (MC).

## Patentansprüche

1. Halbleiterchipstruktur (1), die einen ersten Halbleiterchip (100) aufweist, der einen ersten Chipbereich (CHR1) und einen ersten Ritzrahmen-Bereich (SLR1) enthält, wobei der erste Halbleiterchip an einen zweiten Halbleiterchip (200) gebunden ist, der einen zweiten Chipbereich (CHR2) und einen zweiten Ritzrahmen-Bereich (SLR2) enthält, die jeweils dem ersten Chipbereich und dem ersten Ritzrahmen-Bereich entsprechen,
wobei der erste Halbleiterchip Folgendes umfasst:
eine erste endgültige Verdrahtungsschicht (100c), die ein erstes endgültiges Verdrahtungsmuster (65) und eine erste Passivierungsschicht (64), die das erste endgültige Verdrahtungsmuster isoliert, enthält; und
eine erste Bondverdrahtungsschicht (100d), die auf der ersten endgültigen Verdrahtungsschicht angeordnet ist, wobei die erste Bondverdrahtungsschicht eine erste Bondisolationsschicht (70) und eine erste Bondelektrode (72), die in der ersten Bondisolationsschicht angeordnet ist, enthält,
der zweite Halbleiterchip Folgendes umfasst:
eine zweite endgültige Verdrahtungsschicht (200d), die mindestens ein zweites endgültiges Verdrahtungsmuster (22a, 22b), ein auf dem mindestens einen zweiten endgültigen Verdrahtungsmuster angeordneten Polierstoppmuster (28a, 28b) und eine zweite Passivierungsschicht (32a, 32b), die das mindestens eine zweite endgültige Verdrahtungsmuster und das Polierstoppmuster isoliert, enthält; und
eine zweite Bondverdrahtungsschicht (200e), die auf der zweiten endgültigen Verdrahtungsschicht angeordnet ist, wobei die zweite Bondverdrahtungsschicht eine zweite Bondisolationsschicht (44) und eine zweite Bondelektrode (52), die in der zweiten Bondisolationsschicht angeordnet ist, und das Polierstoppmuster enthält,
wobei die erste Bondisolationsschicht und die erste Bondelektrode der ersten Bondverdrahtungsschicht jeweils an die zweite Bondisolationsschicht und die zweite Bondelektrode der zweiten Bondverdrahtungsschicht hybridgebunden sind, und
mindestens ein Abschnitt einer Bonding-Schnittstelle zwischen der hybridgebundenen ersten Bondisolationsschicht und der ersten Bondelektrode der ersten Bondverdrahtungsschicht zur zweiten Bondisolationsschicht und der zweiten Bondelektrode der zweiten Bondverdrahtungsschicht feinkörniges Kupfer umfasst und ein verbleibender Abschnitt der Bonding-Schnittstelle und ein Innenabschnitt sowohl der ersten Bondelektrode als auch der zweiten Bondelektrode Nanotwin-Kupfer umfasst;
**dadurch gekennzeichnet, dass**
das feinkörnige Kupfer nicht an einer Kante einer obersten Oberfläche der ersten Bondelektrode und an einer Kante der obersten Oberfläche der zweiten Bondelektrode angeordnet ist.

2. Halbleiterchipstruktur nach Anspruch 1, wobei das feinkörnige Kupfer eine Dicke in einem Bereich von etwa 1 µm bis etwa 1,5 µm in Bezug auf die Bonding-Schnittstelle aufweist.

3. Halbleiterchipstruktur nach Anspruch 1 oder 2, wobei das feinkörnige Kupfer eine Korngröße aufweist, die weniger oder gleich etwa 300 nm beträgt.

4. Halbleiterchipstruktur nach einem vorstehenden Anspruch, wobei:
eine Oberfläche von jedem des ersten endgültigen Verdrahtungsmusters (65) und der ersten Passivierungsschicht (64) eine erste ebene Oberfläche ist, die keine Stufenhöhe zwischen dem ersten Chipbereich und dem ersten Ritzrahmen-Bereich aufweist; und
eine Oberfläche von jedem des zweiten endgültigen Verdrahtungsmusters (22a, 22b) und der zweiten Passivierungsschicht (32a, 32b) eine zweite ebene Oberfläche ist, die keine Stufenhöhe zwischen dem zweiten Chipbereich und dem zweiten Ritzrahmen-Bereich aufweist.

5. Halbleiterchipstruktur nach einem vorstehenden Anspruch, wobei die erste Bondisolationsschicht (70) und die zweite Bondisolationsschicht (44) mindestens eine Verbindung umfassen, ausgewählt aus Siliciumcarbidnitrid und Siliciumoxid.

6. Halbleiterchipstruktur nach einem vorstehenden Anspruch, wobei:
die erste Bondelektrode (72) mit dem ersten endgültigen Verdrahtungsmuster (65) elektrisch verbunden ist; und
die zweite Bondelektrode (52) mit mindestens einem des mindestens einen des mindestens einen zweiten endgültigen Verdrahtungsmusters (22a, 22b) elektrisch verbunden ist.

7. Halbleiterchipstruktur nach einem vorstehenden Anspruch, wobei eine Ätzstoppschicht (66) auf dem ersten endgültigen Verdrahtungsmuster (65) und der ersten Passivierungsschicht (64) angeordnet ist.

8. Halbleiterchipstruktur nach einem vorstehenden Anspruch, wobei:
das erste endgültige Verdrahtungsmuster (65) und die erste Bondelektrode (72) jeweils ein unterschiedliches Metallmaterial umfassen; und
das mindestens eine zweite endgültiges Verdrahtungsmuster (22a, 22b) und die zweite Bondelektrode (52) jeweils ein voneinander unterschiedliches Metallmaterial umfassen.

9. Halbleiterchipstruktur nach einem vorstehenden Anspruch, wobei eine Breite der ersten Bondelektrode (72) und eine Breite der zweiten Bondelektrode (52) voneinander unterschiedlich sind.

10. Halbleiterchipstruktur nach Anspruch 1,
wobei der erste Halbleiterchip (100) Folgendes umfasst:
eine erste Schaltungsschicht (100b), die im ersten Chipbereich und im ersten Ritzrahmen-Bereich angeordnet ist, wobei die erste endgültige Verdrahtungsschicht auf der ersten Schaltungsschicht angeordnet ist; und
wobei die erste Bondverdrahtungsschicht eine erste Zwischenschicht-Isolationsschicht (68) enthält, die erste Bondisolationsschicht auf der ersten Zwischenschicht-Isolationsschicht angeordnet ist und die erste Bondelektrode in der ersten Zwischenschicht-Isolationsschicht und der ersten Bondisolationsschicht angeordnet ist,
wobei der zweite Halbleiterchip Folgendes umfasst:
eine zweite Schaltungsschicht (200b), die im zweiten Chipbereich und im zweiten Ritzrahmen-Bereich angeordnet ist, wobei die zweite endgültige Verdrahtungsschicht auf der zweiten Schaltungsschicht angeordnet ist; und
wobei die zweite Bondverdrahtungsschicht eine zweite Zwischenschicht-Isolationsschicht (40) enthält, die zweite Bondisolationsschicht auf der zweiten Zwischenschicht-Isolationsschicht angeordnet ist und die zweite Bondelektrode in der zweiten Bondisolationsschicht, der zweiten Zwischenschicht-Isolationsschicht und dem Polierstoppmuster angeordnet ist;
wobei die erste Bondelektrode einen ersten Abschnitt umfasst, der die oberste Oberfläche mit feinkörnigem Kupfer beschichtet aufweist und Nanotwin-Kupfer, das eine Seitenfläche des ersten Abschnitts umgibt und den inneren Abschnitt der ersten Bondelektrode ausfüllt; und
wobei die zweite Bondelektrode einen zweiten Abschnitt umfasst, der die oberste Oberfläche mit feinkörnigem Kupfer beschichtet aufweist und Nanotwin-Kupfer, das eine Seitenfläche des zweiten Abschnitts umgibt und den inneren Abschnitt der zweiten Bondelektrode ausfüllt.

11. Halbleiterchipstruktur nach Anspruch 10, wobei mindestens ein Abschnitt des ersten Abschnitts an mindestens einen Abschnitt des zweiten Abschnitts hybridgebunden ist.

12. Halbleiterchipstruktur nach Anspruch 10 oder 11, wobei das feinkörnige Kupfer so geformt ist, dass es eine Dicke in einem Bereich von etwa 1 µm bis etwa 1,5 µm in Bezug auf eine oberste Oberfläche der ersten Bondelektrode oder der zweiten Bondelektrode aufweist.

13. Halbleiterchipstruktur nach einem der Ansprüche 10 bis 12, wobei das feinkörnige Kupfer eine Korngröße aufweist, die weniger oder gleich etwa 300 nm beträgt.

14. Halbleiterchipstruktur nach einem der Ansprüche 10 bis 13, wobei die erste Schaltungsschicht eine Peripherieschaltung (62) umfasst und die zweite Schaltungsschicht eine Speicherzelle (MC) umfasst.

## Revendications

1. Structure de puce semi-conductrice (1) présentant une première puce semi-conductrice (100) incluant une première région de puce (CHR1) et une première région de voie de traçage (SLR1), la première puce semi-conductrice étant liée à une seconde puce semi-conductrice (200)incluant une seconde région de puce (CHR2) et une seconde région de voie de traçage (SLR2) correspondant respectivement à la première région de puce et à la première région de voie de traçage,
dans laquelle la première puce semi-conductrice comprend :
une première couche de câblage final (100c) incluant un premier motif de câblage final (65) et une première couche de passivation (64) isolant le premier motif de câblage final ; et
une première couche de câblage de liaison (100d) disposée sur la première couche de câblage final, la première couche de câblage de liaison incluant une première couche d'isolation de liaison (70) et une première électrode de liaison (72) disposée dans la première couche d'isolation de liaison,
la seconde puce semi-conductrice comprend :
une seconde couche de câblage final (200d) incluant au moins un second motif de câblage final (22a, 22b), un motif d'arrêt de polissage (28a, 28b) disposé sur l'au moins un second motif de câblage final et une seconde couche de passivation (32a, 32b) isolant l'au moins un second motif de câblage final et le motif d'arrêt de polissage ; et
une seconde couche de câblage de liaison (200e) disposée sur la seconde couche de câblage final, la seconde couche de câblage de liaison incluant une seconde couche d'isolation de liaison (44) et une seconde électrode de liaison (52) disposée dans la seconde couche d'isolation de liaison et le motif d'arrêt de polissage,
dans laquelle la première couche d'isolation de liaison et la première électrode de liaison de la première couche de câblage de liaison sont respectivement liées de manière hybride à la seconde couche d'isolation de liaison et à la seconde électrode de liaison de la seconde couche de câblage de liaison, et
au moins une partie d'une interface de liaison entre la première couche d'isolation liée de manière hybride et la première électrode de liaison de la première couche de câblage de liaison à la seconde couche d'isolation de liaison et la seconde électrode de liaison de la seconde couche de câblage de liaison comprend du cuivre à grains fins et une partie restante de l'interface de liaison et une partie intérieure de chacune de la première électrode de liaison et de la seconde électrode de liaison comprennent du cuivre Nanotwin ;
**caractérisée en ce que**
le cuivre à grains fins n'est pas disposé au niveau d'un bord d'une surface supérieure de la première électrode de liaison et au niveau d'un bord d'une surface supérieure de la seconde électrode de liaison.

2. Structure de puce semi-conductrice selon la revendication 1, dans laquelle le cuivre à grains fins présente une épaisseur comprise dans une plage d'environ 1 µm à environ 1,5 µm par rapport à l'interface de liaison.

3. Structure de puce semi-conductrice selon la revendication 1 ou 2, dans laquelle le cuivre à grains fins présente une taille de grain qui est inférieure ou égale à environ 300 nm.

4. Structure de puce semi-conductrice selon une quelconque revendication précédente, dans laquelle :
une surface de chacun du premier motif de câblage final (65) et de la première couche de passivation (64) est une première surface plane qui ne présente pas de différence de hauteur entre la première région de puce et la première région de voie de traçage ; et
une surface de chacun du second motif de câblage final (22a, 22b) et de la seconde couche de passivation (32a, 32b) est une seconde surface plane qui ne présente pas de différence de hauteur entre la seconde région de puce et la seconde région de voie de traçage.

5. Structure de puce semi-conductrice selon une quelconque revendication précédente, dans laquelle la première couche d'isolation de liaison (70) et la seconde couche d'isolation de liaison (44) comprennent au moins un composé sélectionné parmi le nitrure de carbure de silicium et l'oxyde de silicium.

6. Structure de puce semi-conductrice selon une quelconque revendication précédente, dans laquelle :
la première électrode de liaison (72) est connectée électriquement au premier schéma de câblage final (65) ; et
la seconde électrode de liaison (52) est connectée électriquement à au moins un de l'au moins un second schéma de câblage final (22a, 22b).

7. Structure de puce semi-conductrice selon une quelconque revendication précédente, dans laquelle une couche d'arrêt de gravure (66) est disposée sur le premier motif de câblage final (65) et la première couche de passivation (64).

8. Structure de puce semi-conductrice selon une quelconque revendication précédente, dans laquelle :
le premier schéma de câblage final (65) et la première électrode de liaison (72) comprennent respectivement un matériau métallique différent l'un de l'autre ; et
l'au moins un second schéma de câblage final (22a, 22b) et la seconde électrode de liaison (52) comprennent respectivement un matériau métallique différent l'un de l'autre.

9. Structure de puce semi-conductrice selon une quelconque revendication précédente, dans laquelle une largeur de la première électrode de liaison (72) et une largeur de la seconde électrode de liaison (52) sont différentes l'une de l'autre.

10. Structure de puce semi-conductrice selon la revendication 1,
dans laquelle la première puce semi-conductrice (100) comprend :
une première couche de circuit (100b) disposée dans la première région de puce et la première région de voie de traçage, dans laquelle la première couche de câblage final est disposée sur la première couche de circuit ; et
dans laquelle la première couche de câblage de liaison inclut une première couche d'isolation intercouche (68), la première couche d'isolation de liaison étant disposée sur la première couche d'isolation intercouche et la première électrode de liaison étant disposée dans la première couche d'isolation intercouche et la première couche d'isolation de liaison,
dans laquelle la seconde puce semi-conductrice comprend :
une seconde couche de circuit (200b) disposée dans la seconde région de puce et la seconde région de voie de traçage, dans laquelle la seconde couche de câblage final est disposée sur la seconde couche de circuit ; et
dans laquelle la seconde couche de câblage de liaison inclut une seconde couche d'isolation intercouche (40), la seconde couche d'isolation de liaison étant disposée sur la seconde couche d'isolation intercouche et la seconde électrode de liaison étant disposée dans la seconde couche d'isolation de liaison, la deuxième couche d'isolation intercouche et le motif d'arrêt de polissage ;
dans laquelle la première électrode de liaison comprend une première partie présentant la surface supérieure plaquée de cuivre à grains fins et du cuivre Nanotwin entourant une surface latérale de la première partie et remplissant la partie intérieure de la première électrode de liaison ;
dans laquelle la seconde électrode de liaison comprend une seconde partie présentant la surface supérieure plaquée de cuivre à grains fins et du cuivre Nanotwin entourant une surface latérale de la seconde partie et remplissant la partie intérieure de la seconde électrode de liaison.

11. Structure de puce semi-conductrice selon la revendication 10, dans laquelle au moins une partie de la première partie est liée de manière hybride à au moins une partie de la seconde partie.

12. Structure de puce semi-conductrice selon la revendication 10 ou 11, dans laquelle le cuivre à grains fins est formé pour présenter une épaisseur dans une plage d'environ 1 µm à environ 1,5 µm par rapport à une surface supérieure de la première électrode de liaison ou de la seconde électrode de liaison.

13. Structure de puce semi-conductrice selon l'une quelconque des revendications 10 à 12, dans laquelle le cuivre à grains fins présente une taille de grain qui est inférieure ou égale à environ 300 nm.

14. Structure de puce semi-conductrice selon l'une quelconque des revendications 10 à 13, dans laquelle la première couche de circuit comprend un circuit périphérique (62) et la seconde couche de circuit comprend une cellule de mémoire (MC).
